# EUROPÄISCHE PATENTSCHRIFT

(11) **EP 4 689 522 B1**
(45) Veröffentlichungstag und Bekanntmachung des Hinweises auf die Patenterteilung: **22.04.2026**
(21) Anmeldenummer: 24731558.3
(22) Anmeldetag: 06.06.2024
(51) Int. Cl.: F28D 1/03, F28F 3/12, F28F 9/02, H01M 10/65, H05K 7/20, F28D 21/00, H01M 10/613, H01M 10/6554, H01M 10/6556, H01M 10/6567

(54) **KÜHLBAUTEIL UND VERFAHREN ZUR HERSTELLUNG DESSELBEN**
COOLING DEVICE AND METHOD OF MANUFACTURING THE SAME
DISPOSITIF DE REFROIDISSEMENT ET PROCÉDÉ DE SON FABRICATION

(30) Priorität: 07.06.2023 DE 102023114998
(43) Veröffentlichungstag der Anmeldung: 11.02.2026
(73) Patentinhaber: Erwin Quarder Systemtechnik GmbH, 32339 Espelkamp (DE)
(72) Erfinder: HEITBRINK, Alexander, 32351 Stemwede (DE); LÖTKEMANN, David, 32369 Rahden (DE)
(74) Vertreter: Geskes, Christoph
(86) Internationale Anmeldenummer: PCT/EP2024/065526
(87) Internationale Veröffentlichungsnummer: WO 2024/251850

(56) Entgegenhaltungen:
- DE-A1- 102007 003 920
- US-A1- 2014 090 811
- US-A1- 2020 106 146
- US-A1- 2023 006 281

## Beschreibung

Die vorliegende Erfindung betrifft ein Kühlbauteil zu Kühlen von Gegenständen, mit mindestens einem vorzugsweise beschichteten, einen Kühlkörper bildenden, metallischen Profil sowie ein Verfahren zur Herstellung eines solchen Kühlbauteils.

Kühlbauteile zum Abführen von Wärme von zu kühlenden Gegenständen werden auch als Wärmetauscher bezeichnet und in vielen Bereichen der Technik eingesetzt. Besondere Bedeutung kommt solchen Kühlbauteilen unter anderem bei der Kühlung von Batterie- beziehungsweise Akkumulatorensystemen für Elektrofahrzeuge zu, aber auch von Leistungselektronikbauteilen, von Busbars oder von Prozessorchips. Die eingangs genannten Kühlbauteile sind dabei in der Regel Bestandteil einer übergeordneten Kühleinrichtung, die dafür sorgt, dass Kühlmedium, wie zum Beispiel Wasser oder dergleichen, kontinuierlich durch das Kühlbauteil geführt wird. Solche Kühlbauteile müssen häufig je nach Einsatzgebiet in besondere Weise individualisiert werden, was hohe Kosten nach sich zieht.

Kühlkörper derartiger Kühlbauteile, die im Betrieb in der Regel an dem zu kühlenden Gegenstand anliegen, zumindest aber in der unmittelbaren Nähe desselben angeordnet sind, sind dabei häufig aus einzelnen Bauteilen aus Metall oder einer Metalllegierung, wie beispielsweise Stahl hergestellt, die aufwändig miteinander verschweißt oder verlötet sind. Das mit dem Kühlkörper verbundene Anschlussteil zum Zu- und/oder Abführen von Kühlmedium besteht häufig aus demselben Metall beziehungsweise aus derselben Metalllegierung wie der Kühlkörper und ist mit diesem ebenfalls aufwändig verschweißt oder verlötet. Da solche Anschlussteile in der Regel allerdings nicht für die unmittelbare Wärmeübertragung von dem zu kühlenden Gegenstand auf das Kühlbauteil gedacht sind, wäre es eigentlich nicht erforderlich, auch die Anschlussteile aus hochwärmeleitendem, metallischem Material herzustellen. Dies ist funktional sogar eher kontraproduktiv.

US 2023/0006281 A1 offenbart ein Wärmemanagementsystem für eine elektrische Komponente umfassend ein Gehäuse für die elektrische Komponente und eine Wärmeaustauschplatte, die sich über die Oberfläche der Seitenfläche des Gehäuses erstreckt. Die Platte weist einen Flüssigkeitskanal zwischen einem Flüssigkeitseinlass und einem Flüssigkeitsauslass, einen Zufuhrkanal zur Versorgung der Platte mit Flüssigkeit und einen Abfuhrkanal sowie ein Gehäuse auf, das das Gehäuse bzw. die Gehäuse definiert und die Wärmeaustauschplatte sowie den Zufuhr- und den Abfuhrkanal aufnimmt. DE 10 2007 003920 A1betrifft einen Flüssigkeitskühler für ein oder mehrere elektrische oder elektronische Bauteile, mit einer unteren Kühlplatte, an deren unteren Seite eine oder mehrere zu kühlende Bauteile angeordnet werden können und in deren oberen Seite Kühlmittelkanäle als Nuten ausgebildet sind, die im Wesentlichen parallel zur Flächenebene der unteren Kühlplatte ausgerichtet sind, mit einer oberen Kühlplatte, an deren oberen Seite eine oder mehrere zu kühlende Bauteile angeordnet werden können und in deren unteren Seite Kühlmittelkanäle als Nuten ausgebildet sein können, die im Wesentlichen parallel zur Flächenebene der oberen Kühlplatte ausgerichtet sind und vorzugsweise deckungsgleich, somit spiegelverkehrt, zu den Kühlmittelkanälen in der unteren Kühlplatte ausgebildet sind, mit Ausbildung zumindest einer Zuführungsdurchgangsstichbohrung und wenigstens einer Abführungsdurchgangsstichbohrung in der oberen oder unteren Kühlplatte für das Kühlmittel in Richtung der in Richtung der Flächennormalen der Kühlplatten, die mit den Kühlmittelkanälen in Strömungsverbindung stehen.

Es ist Aufgabe der vorliegenden Erfindung, das eingangs genannte Kühlbauteil weiterzuentwickeln sowie ein Verfahren zur Herstellung eines solchen weiterentwickelten Kühlbauteils anzugeben.

Diese Aufgabe wird gelöst mittels eines Kühlbauteils zum Kühlen von Gegenständen, mit mindestens einem einen Kühlkörper bildenden, metallischen Profil, wobei das Profil mehrere parallele Mediumkanäle zum Durchfluss von Kühlmedium aufweist, von denen jeder jeweils von einer umlaufenden, durch das Profil gebildeten Mediumkanalwandung begrenzt wird, und mit einem mit dem Profil fluiddicht verbundenen ersten Anschlussteil aus Kunststoff mit Zulauf- und/oder Ablauföffnung, über die dem Kühlbauteil Kühlmedium zuführbar ist und/oder über die Kühlmedium aus dem Kühlbauteil abführbar ist, wobei die umlaufende Mediumkanalwandung mindestens eines der parallelen Mediumkanäle im Bereich des ersten Anschlussteils eine Durchgangsöffnung aufweist, über die der Mediumkanal fluidleitend mit der Zulauf- und/oder mit der Ablauföffnung des ersten Anschlussteils verbunden ist, wobei das Profil ausgebildet ist mit einer ersten großflächigen Außenseite und mit einer von dieser beabstandeten zweiten großflächigen Außenseite, wobei die oder jede im Bereich des ersten Anschlussteils angeordnete Durchgangsöffnung an der ersten oder der zweiten großflächigen Außenseite des Profils angeordnet ist.

Weiterhin wird die Aufgabe gelöst mittels eines Verfahrens zur Herstellung eines Kühlbauteils, das mindestens ein einen Kühlkörper bildendendes, metallisches Profil aufweist, das über mehrere parallele Mediumkanäle zum Durchfluss von Kühlmedium verfügt, von denen jeder jeweils seitlich von einer umlaufenden, durch das Profil gebildeten Mediumkanalwandung begrenzt wird, und mit einem mit dem Profil fluiddicht verbundenen ersten Anschlussteil aus Kunststoff mit Zulauf- und/oder Ablauföffnung, über die dem Kühlbauteil Kühlmedium zuführbar ist und/oder über die Kühlmedium aus dem Kühlbauteil abführbar ist, wobei die umlaufende Mediumkanalwandung mindestens eines der parallelen Mediumkanäle, im Bereich des ersten Anschlussteils eine Durchgangsöffnung aufweist, über die der Mediumkanal fluidleitend mit der Zulauf- und/oder mit der Ablauföffnung des ersten Anschlussteils verbunden ist, , wobei das Profil ausgebildet ist mit einer ersten großflächigen Außenseite und mit einer von dieser beabstandeten zweiten großflächigen Außenseite, wobei die oder jede im Bereich des ersten Anschlussteils angeordnete Durchgangsöffnung an der ersten oder der zweiten großflächigen Außenseite des Profils angeordnet ist, mit folgenden Maßnahmen:
a) Einbringen der Durchgangsöffnung in ein vorgefertigtes, metallisches, die Mediumkanäle und die Mediumkanalwandungen aufweisendes Profil in Form einer in die umlaufende Mediumkanalwandung eingebrachten Freimachung,
b) Fluiddichtes Verbinden eines vorgefertigten Anschlussteils aus Kunststoff mit Zulauf- und/oder Ablauföffnung im Bereich der Durchgangsöffnung.

Erfindungsgemäß wird demnach ein Kühlbauteil angegeben zum Kühlen von Gegenständen, das über mindestens ein vorzugsweise beschichtetes, einen Kühlkörper bildendes, metallisches Profil verfügt, vorzugsweise ein Extrusionsprofil beziehungsweise ein extrudiertes Profil, wie beispielsweise ein Strangpressprofil, insbesondere aus Aluminium. Dieses insbesondere längliche Profil weist mehrere parallele, insbesondere längliche Mediumkanäle zum Durchfluss von Kühlmedium auf, von denen jeder jeweils seitlich von einer umlaufenden, insbesondere im Querschnitt rechteckförmig oder rund umlaufenden, durch das Profil gebildeten Mediumkanalwandung begrenzt wird. Das Profil ist fluiddicht verbundenen mit einem ersten Anschlussteil aus Kunststoff mit einer Zulauf- und/oder einer Ablauföffnung, über die dem Kühlbauteil Kühlmedium zuführbar ist, bevorzugt über die Zulauföffnung, beziehungsweise über die Kühlmedium aus dem Kühlbauteil abführbar ist, bevorzugt über die Ablauföffnung. Dabei weist die umlaufende Mediumkanalwandung mindestens eines Mediumkanals der parallelen Mediumkanäle, vorzugsweise die jeweilige umlaufende Mediumkanalwandung von mehreren oder sämtlichen dieser Mediumkanäle, im Bereich des ersten Anschlussteils eine vorzugsweise durch ein Fertigungsverfahren wie Trennen oder Umformen eingebrachte Durchgangsöffnung auf, über die der Mediumkanal fluidleitend mit der Zulaufbeziehungsweise mit der Ablauföffnung des ersten Anschlussteils verbunden ist. Dies ist erfindungsgemäß eine in die umlaufende Mediumkanalwandung eingebrachte Freimachung.

Im Sinne der Erfindung wird mit dem Wort "beziehungsweise" eine Ausführungsform eines Merkmals gekennzeichnet das zusätzlich oder alternativ verwendet werden kann. Insbesondere ist "beziehungsweise" wie "und/oder" zu verstehen.

Das eingangs genannte Verfahren zur Herstellung eines Kühlbauteils, insbesondere des oben genannten Kühlbauteils, umfasst erfindungsgemäß folgende Maßnahmen:
a) Einbringen der Durchgangsöffnung in ein vorgefertigtes, metallisches, die Mediumkanäle und die Mediumkanalwandungen aufweisendes Profil in Form einer in die umlaufende Mediumkanalwandung eingebrachten Freimachung, insbesondere mittels einem Trenn- und/oder Umformverfahren, wie beispielsweise Bohren, Stanzen, Pressen und/oder Biegen, vorzugsweise mittels Laser, Bohreinrichtung, Stanzeinrichtung, Presseinrichtung und/oder Biegeeinrichtung,
b) Fluiddichtes Verbinden eines vorgefertigten, insbesondere spritzgegossenen Anschlussteils aus Kunststoff mit Zulauf- und/oder Ablauföffnung im Bereich der Durchgangsöffnung, insbesondere durch Verpressen von Verbindungsflächen des Anschlussteils mit Verbindungsflächen des Profils, vorzugsweise unter Verwendung von Wärme zum Aufschmelzen der Verbindungsflächen des Anschlussteils.

Die erfindungsgemäße Verwendung mindestens eines metallischen, das heißt aus gegebenenfalls beschichtetem Metall oder einer Metalllegierung bestehenden Profils zusammen mit mindestens einem Anschlussteil aus Kunststoff ermöglicht zum einen eine kostengünstige Herstellung eines solchen Kühlbauteils, da auf standardisierte und gut bekannte Herstellungsprozesse von metallischen Profilen zurückgegriffen werden kann, insbesondere Extrusionsprozesse.

Weiter ist die erfindungsgemäße Verwendung eines Anschlussteils aus Kunststoff zum einen deutlich kostengünstiger als die Verwendung eines Anschlussteils aus Metall beziehungsweise Metalllegierungen und zum anderen kann die vergleichsweise geringe Wärmeleitfähigkeit von Kunststoff in diesem Zusammenhang funktional vorteilhaft sein, um beispielsweise einen ungewollten Wärmeübertrag auf das Kühlmedium im Bereich des Anschlussteils zu verhindern.

Schließlich ist es erfindungsgemäß möglich, bei Verwendung ansonsten gleichartiger Profile nur durch Einbringung unterschiedlicher Durchgangsöffnungen in die Profile, beispielsweise in Größe, Gestalt, Profil, Anordnung ,an verschiedene Einsatzsituationen angepasste Kühlbauteile herzustellen.

Beispielhafte Aufzählungen sind im Sinne der Erfindung als nicht abschließend anzusehen, sondern können im Rahmen des allgemeinen Fachwissens ergänzt werden.

Gleichermaßen ermöglicht es die Erfindung auch, unterschiedliche Kühlbauteile zu konfigurieren, indem für ansonsten gleichartige Profile, die gegebenenfalls auch jeweils sogar identische Durchgangsöffnungen aufweisen können, unterschiedliche Kunststoff-Anschlussteile verwendet werden.

Gemäß einer ersten Weiterbildung der Erfindung können die parallelen Mediumkanäle an ihren gegenüberliegenden Enden stirnseitig verschlossen sein. Insbesondere, indem sich gegenüberliegende Abschnitte der jeweiligen umlaufenden Mediumkanalwandung des jeweiligen Mediumkanals fluiddicht miteinander verbunden sind. Dies vorzugsweise kraft- und/oder stoffschlüssig, besonders bevorzugt unter Verpressung und/oder Verschweißung der sich gegenüberliegenden Abschnitte.

Was die Durchgangsöffnung oder Durchgangsöffnungen betrifft, so können die umlaufenden Mediumkanalwandungen einer Gruppe von nebeneinander angeordneten Mediumkanälen eine gemeinsame, zusammenhängende, insbesondere sich quer zu den Mediumkanälen erstreckende Profilöffnung bilden. Beispielsweise bei einem im Wesentlichen quaderförmigen Profil mit in Längserstreckung verlaufenden, parallelen Mediumkanälen können beispielsweise jeweils obere Wandabschnitte der umlaufenden Mediumkanalwandungen in einer gemeinsamen Ebene liegen und dabei gemeinsam die obere, die erste großflächige Außenseite des quaderförmigen Profils umfassende Profilwandung bilden, während untere, in einer gemeinsamen Ebene liegende Wandabschnitte der umlaufenden Mediumkanalwandungen entsprechend gemeinsam die untere, die zweite großflächige Außenseite des Profils umfassende Profilwandung bilden. In diesem Fall könnte die genannte Profilöffnung und/oder Durchgangsöffnung jeweils eine quer zu der Längserstreckung der Mediumkanäle verlaufende Öffnung in der oberen oder unteren Profilwandung sein, die dann entsprechend gleichzeitig die einzelnen Durchgangsöffnungen in den oberen jeweiligen Mediumkanalwandungen umfasst beziehungsweise bildet. Entsprechend wären die einzelnen Durchgangsöffnungen der Mediumkanalwandungen dieser Gruppe von Mediumkanäle nicht voneinander bestandet, sondern würden ineinander übergehen.

Alternativ ist aber auch denkbar, dass die Durchgangsöffnungen der umlaufenden Mediumkanalwandungen einer Gruppe von jeweils nebeneinander angeordneten Mediumkanälen des Profils jeweils durch von dem Profil, insbesondere den umlaufenden Mediumkanalwandungen gebildeten, vorzugsweise parallelen Materialstegen voneinander getrennt sind. In dem obigen Beispiel eines im Wesentlichen quaderförmigen Profils könnten diese Durchgangsöffnungen beispielsweise parallele Schlitze sein in der oberen oder unteren Profilwandung beziehungsweise in den oberen oder unteren Wandabschnitten der in der gemeinsamen Ebene liegenden Wandabschnitte der umlaufenden Mediumkanalwandungen.

Vorzugsweise können demnach nicht nur die genannten Wandabschnitte der Mediumkanalwandungen in einer gemeinsamen Ebene angeordnet sein, sondern allgemein gesprochen können dementsprechend auch die Durchgangsöffnungen der umlaufenden Mediumkanalwandungen einer Gruppe von jeweils nebeneinander angeordneten Mediumkanälen des Profils in einer gemeinsamen, insbesondere ungekrümmten Ebene angeordnet sein.

Weiter kann für mehrere oder sämtliche Mediumkanäle des Profils im Übrigen gelten, dass die umlaufenden Mediumkanalwandungen von jeweils zwei benachbarten Mediumkanälen einen gemeinsamen, zwischen ihnen angeordneten und sich vorzugsweise von einem Ende des Profils bis zum anderen Ende des Profils erstreckenden Wandabschnitt aufweisen, an den die beiden benachbarten Mediumkanäle jeweils angrenzen.

Dabei kann vorgesehen sein, dass der gemeinsame Wandabschnitt der umlaufenden Mediumkanalwandung der beiden benachbarten Mediumkanäle in mindestens einem Bereich, insbesondere in mindestens einem Endbereich der benachbarten Mediumkanäle, unterbrochen ist oder eine Verbindungsöffnung aufweist, sodass dort Kühlmedium von dem einen zu dem anderen Mediumkanal strömen kann. Dabei kann konkret vorgesehen sein, dass der gemeinsame Wandabschnitt die beiden benachbarten Mediumkanäle außerhalb des oder jedes Bereichs, in dem der Wandabschnitt unterbrochen ist oder außerhalb der oder jeder Verbindungsöffnung fluiddicht voneinander trennt, sodass dort Kühlmedium nicht von dem einen zum anderen Mediumkanal strömen kann.

Auf die vorgenannte Weise, als die Unterbrechung beziehungsweise die Verbindungsöffnung, wäre eine direkte Verbindung dieser Mediumkanäle möglich. Nur beispielsweise für den Fall, dass einer der beiden benachbarten Mediumkanäle beziehungsweise deren zugeordnete umlaufende Mediumkanalwandung im Bereich eines ersten Endes des Profils eine Durchgangsöffnung aufweist, durch die Kühlmedium über das Anschlussteil zuführbar ist, könnte das Kühlmedium den Mediumkanal durchströmen und dann im Bereich eines zweiten Endes über die Verbindungsöffnung beziehungsweise die Unterbrechung direkt zu dem anderen Mediumkanal strömen, ohne dass dort ebenfalls eine solche mit einem oder dem Anschlussteil fluidleitend verbundene Durchgangsöffnung erforderlich ist und kann dann anschließend in dem anderen Mediumkanal weitergeführt werden, insbesondere zurück dem ersten Ende. Ausgehend von diesem Konzept, nämlich der Nutzung von Verbindungsöffnungen zwischen benachbarten Mediumkanälen, das natürlich auch auf eine Gruppe von mehr als zwei jeweils in dieser Weise benachbarten Mediumkanälen übertragbar ist, sind diverse verschiedene Varianten denkbar, um die Kühlmediumströmung in dem Kühlbauteil zu gestalten und gezielt zu steuern. Vorteilhaft ist eine Einzelkanalsteuerung möglich, bei der ein Fluss des Kühlmediums gezielt durch die einzelnen Mediumkanäle führbar ist.

Weiter kann vorgesehen sein, dass von parallel verlaufenden Mediumkanälen eine erste Teilgruppe jeweils eine Durchgangsöffnung aufweist, über die der jeweilige Mediumkanal fluidleitend mit der Zulauf- beziehungsweise der Ablauföffnung des ersten Anschlussteils verbunden ist, und eine zweite Teilgruppe jeweils eine Durchgangsöffnung, über die der jeweilige Mediumkanal gezielt nicht fluidleitend mit der Zulauf- beziehungsweise der Ablauföffnung des ersten Anschlussteils verbunden ist, sondern die, insbesondere durch das erste Anschlussteil, nach außen hin fluiddicht verschlossen ist.

Dies kann beispielsweise mittels einer geeigneten Wandung des Anschlussteils geschehen, die die Durchgangsöffnung nach dem fluiddichten Verbinden des Anschlussteils mit dem Profil überdeckt, sodass kein Kühlmedium durch die Durchgangsöffnung fließen kann. Auch die Nutzung einer Art "Totkammer" ist denkbar, in die das Kühlmedium zwar durch die Durchgangsöffnung strömen kann, die aber nach außen hin abgeschlossen ist und insbesondere keine fluidleitende Verbindung mit der Zulauf- oder Ablauföffnung des Anschlussteils hat.

Auf diese Weise können beispielsweise Durchgangsöffnungen in einem Profil, die im Rahmen einer bestimmten Anwendung nicht benutzt werden sollen, durch die Verwendung eines entsprechend ausgebildeten Anschlussteils verschlossen werden, das dann für dieses Verschließen sorgt. Mit anderen Worten könnte bereits bei der Montage eines Kühlbauteils bei Verwendung eines bestimmten Profils, der über Mediumkanäle verfügt, in deren umlaufende Mediumkanalwandungen bereits bestimmte Durchgangsöffnungen eingebracht worden sind beziehungsweise angeordnet sind, ein Anschlussteil ausgewählt werden, das gezielt bestimmte Durchgangsöffnungen verschließt.

Eine beispielhafte Einzelkanalsteuerung ermöglicht es, ein Kühlmedium von einer Zulaufkammer im Anschlussteil in einzelne oder mehrere ausgewählte Mediumkanäle zu leiten. Von dort kann das Medium mittels eines Verbindungsteils in weitere Mediumkanäle umgelenkt werden. Die Umlenkung des Kühlmediums kann ebenfalls direkt im Anschlussteil erfolgen, sodass das Medium in definierten Kanälen fließt, bis es schließlich in die Ablaufkammer geleitet wird.

Das Anschlussteil und das Verbindungsteil können in einer beispielhaften Ausgestaltung Umlenkräume aufweisen, um die Strömung des Kühlmediums zwischen den verschiedenen Mediumkanälen zu ermöglichen. In diesen Umlenkräumen wird das Kühlmedium gezielt von einem Mediumkanal in einen anderen Mediumkanal, bevorzugt einem benachbarten Mediumkanal umgeleitet. Dies ermöglicht eine flexible und kontrollierte Steuerung des Kühlmediums durch die verschiedenen Mediumkanäle des Kühlbauteils.

Alternativ können Anschlussteil und Verbindungsteil ohne Umlenkräume gestaltet sein. Stattdessen können beispielhaft Unterbrechungen in den Wänden der Mediumkanäle vorgesehen werden. Insbesondere kann, wie oben beschrieben, der gemeinsame Wandabschnitt der umlaufenden Mediumkanalwandung der beiden benachbarten Mediumkanäle in mindestens einem Bereich, insbesondere in mindestens einem Endbereich der benachbarten Mediumkanäle, unterbrochen sein oder eine Verbindungsöffnung aufweisen, sodass dort Kühlmedium von dem einen zu dem anderen Mediumkanal strömen kann. Diese Unterbrechungen oder Verbindungsöffnungen erlauben es dem Kühlmedium, von einem Mediumkanal direkt in den benachbarten Mediumkanal zu strömen. In diesem Fall dichten das Anschlussteil und das Verbindungsteil die Öffnungen der Mediumkanäle nach Außen ab, während das Kühlmedium durch die Verbindungsöffnungen zwischen den Mediumkanälen fließen kann.

Eine Kombination beider Varianten ist ebenfalls möglich, wobei sowohl Umlenkräume als auch Verbindungsöffnungen in den Kanalwänden verwendet werden können. Dies bietet den Vorteil, dass die Kühlleistung und Strömungswege des Kühlmediums noch flexibler und genauer an den spezifischen Kühlbedarf angepasst werden können. Die Einzelkanalsteuerung ermöglicht somit eine präzise Steuerung des Kühlmediums entsprechend der zu erwartenden Wärmeabgabe der zu kühlenden Komponente, wie beispielsweise einer Batterie.

Was den Aufbau des Profils betrifft, so ist dieses regelmäßig einstückig ausgebildet. Erfindungsgemäß weist das Profil eine erste großflächige, insbesondere ebene, gebogene oder gewellte Außenseite und eine von dieser beabstandete, zu dieser insbesondere parallel verlaufende, zweite großflächige, insbesondere ebene, gebogene oder gewellte Außenseite, sowie vorzugsweise zwei voneinander beabstandete, die erste und die zweite großflächige Außenseite jeweils miteinander verbindenden, insbesondere ebene, gebogene oder gewellte schmale Außenseiten.

Die oder jede im Bereich des ersten Anschlussteils angeordnete Durchgangsöffnung kann dann im Übrigen an der ersten oder der zweiten großflächigen Außenseite des Profils angeordnet sein.

Erfindungsgemäß ist die oder jede im Bereich des ersten Anschlussteils angeordnete Durchgangsöffnung im Bereich eines ersten Endes des Profils angeordnet, insbesondere mit Abstand zu diesem. Alternativ können sie auch in einem mittigen Bereich des Profils angeordnet sein.

Das erste Anschlussteil kann auch eine die Zulauföffnung umfassende Zulaufkammer aufweisen, in die die Durchgangsöffnung der umlaufenden Mediumkanalwandung des gegebenenfalls jeweiligen Mediumkanals mündet, und über die der Mediumkanal fluidleitend mit der Zulauföffnung verbunden ist. In einer Ausgestaltung umfasst die Zulaufkammer eine Vielzahl, bevorzugt zumindest zwei Kammerteile, die kommunizierend miteinander verbunden sind. Alternativ oder zusätzlich kann das erste Anschlussteil auch eine insbesondere von der Zulaufkammer getrennte, die Ablauföffnung umfassende Ablaufkammer aufweisen, in die die Durchgangsöffnung der umlaufenden Mediumkanalwandung des gegebenenfalls jeweiligen Mediumkanals mündet, über die der Mediumkanal fluidleitend mit der Ablauföffnung verbunden ist. In einer Ausgestaltung umfasst die Ablaufkammer eine Vielzahl, bevorzugt zumindest zwei Kammerteile, die kommunizierend miteinander verbunden sind. Alternativ oder zusätzlich umfasst das erste Anschlussteil einen Umlenkraum, mittels dem bevorzugt ein Kühlmedium von mindesteins einem ersten Mediumkanal in mindestens einen zweiten Mediumkanal umlenkbar ist.

Was die umlaufende Mediumkanalwandung des gegebenenfalls jeweiligen Mediumkanals betrifft, vorzugsweise die jeweilige umlaufende Mediumkanalwandung der mehreren oder sämtlicher Mediumkanäle, so kann diese im Bereich eines zweiten mit dem Profil fluiddicht verbundenen Anschlussteils aus Kunststoff eine weitere Durchgangsöffnung aufweisen, insbesondere eine in die umlaufende Mediumkanalwandung eingebrachte Freimachung, über die der Mediumkanal fluidleitend mit einer Zulauf- oder Ablauföffnung des weiteren Anschlussteils verbunden ist.

Die umlaufende Mediumkanalwandung des gegebenenfalls jeweiligen Mediumkanals, vorzugsweise die jeweilige umlaufende Mediumkanalwandung der mehreren oder sämtlicher Mediumkanäle, kann auch im Bereich eines fluiddicht mit dem Profil verbundenen, insbesondere das Kühlmedium umlenkenden Verbindungsteils aus Kunststoff eine weitere Durchgangsöffnung aufweisen, über die dieser Mediumkanal fluidleitend mit einem Innenraum des Verbindungsteils verbunden ist, wobei dieser Innenraum wiederum mit mindestens einem weiteren der parallelen Mediumkanäle fluidleitend verbunden ist über eine im Bereich des Verbindungsteils angeordnete Durchgangsöffnung in der umlaufenden Mediumkanalwandung des weiteren Mediumkanals. Alternativ oder zusätzlich umfasst das Verbindungsteil einen Umlenkraum, mittels dem bevorzugt ein Kühlmedium von mindesteins einem ersten Mediumkanal in mindestens einen zweiten Mediumkanal umlenkbar ist.

Das zweite Anschlussteil oder das Verbindungsteil sowie die oder jede im Bereich des zweiten Anschlussteils beziehungsweise des Verbindungsteils angeordnete Durchgangsöffnung kann dabei mit Abstand im Bereich eines dem ersten Ende gegenüberliegenden zweiten Ende des Profils angeordnet sein, und zwar mit Abstand zu dem zweiten Ende. Alternativ kann auch vorgesehen sein, dass das zweite Anschlussteil zusammen mit dem ersten Anschlussteil in einem mittigen Bereich des Profils angeordnet ist.

Denkbar ist auch, dass das erste Anschlussteil und/oder das zweite Anschlussteil und/oder das Verbindungsteil, insbesondere ein oder mehrere Wandungen desselben, derart ausgebildet ist, dass es mindestens einen Mediumkanal von der Zulaufkammer oder der Ablaufkammer des ersten Anschlussteils beziehungsweise des zweiten Anschlussteils trennt oder von dem Innenraum des Verbindungsteils, sodass kein Kühlmedium zwischen dieser Durchgangsöffnung einerseits und der Zulaufkammer beziehungsweise der Ablaufkammer beziehungsweise dem Innenraum andererseits strömen kann. Dies kann insbesondere einen Mediumkanal betreffen, der in seiner umlaufenden Mediumkanalwandung im Bereich des ersten Anschlussteils oder des zweiten Anschlussteils oder des Verbindungsteils eine vorzugsweise durch Trennen und/oder Umformen eingebrachte Durchgangsöffnung aufweist.

Auf diese Weise könnte durch die Ausbildung des jeweiligen Anschlussteils und/oder Verbindungsteils beziehungsweise durch die Verwendung unterschiedlich ausgebildeter Anschlussteile/Verbindungsteile gezielt darauf Einfluss genommen werden, welche der in dem jeweiligen Profil vorhandenen Mediumkanäle, deren umlaufende Mediumkanalwandung mit einer Durchgangsöffnung versehen ist, tatsächlich in der jeweiligen Anwendung verwendet werden und welche nicht. Beispielsweise könnte ein Mediumkanal, der in einer bestimmten Anwendung nicht benötigt wird, in dessen Mediumkanalwandung des insbesondere vorgefertigten Profils aber eine Durchgangsöffnung vorhanden ist, durch eine entsprechende, die Durchgangsöffnung absperrende Wandung des Anschlussteils und/oder des Verbindungsteils abgesperrt beziehungsweise totgelegt werden, sodass durch diesen kein Kühlmedium fließt.

Ausgehend von diesem Konzept, nämlich der gezielten Ausbildung des jeweiligen Anschlussteils beziehungsweise des Verbindungsteils, sind diverse verschiedene Varianten denkbar, um die Kühlmediumströmung in dem Kühlbauteil zu gestalten und gezielt zu steuern.

In ähnlicher Weise kann vorgesehen sein, dass das erste Anschlussteil und/oder das zweite Anschlussteil und/oder das Verbindungsteil, insbesondere ein oder mehrere Wandungen desselben, derart ausgebildet ist, dass es zwar einerseits mindestens zwei insbesondere benachbarte Mediumkanäle, die jeweils in deren umlaufender Mediumkanalwandung im Bereich des ersten Anschlussteils oder des zweiten Anschlussteils oder des Verbindungsteils eine, vorzugsweise durch Trennen und/oder Umformen eingebrachte, Durchgangsöffnung aufweisen, von der Zulauföffnung oder von der Ablauföffnung des ersten Anschlussteils beziehungsweise des zweiten Anschlussteils trennt oder von einem mit Durchgangsöffnungen von umlaufenden Mediumkanalwandungen anderer Mediumkanäle in Verbindung stehendem Innenraum des Verbindungsteils, sodass insbesondere kein Kühlmedium zwischen den Durchgangsöffnungen in den umlaufenden Mediumkanalwandungen der insbesondere benachbarten Mediumkanälen einerseits und der Zulaufkammer beziehungsweise der Ablaufkammer beziehungsweise diesem Innenraum andererseits strömen kann, dass es aber andererseits einen fluidleitenden Verbindungskanal zwischen diesen Mediumkanälen herstellt.

Beispielsweise könnte das Anschlussteil/das Verbindungsteil beziehungsweise entsprechende Wandungen desselben so ausgebildet sein, dass die Durchgangsöffnungen von umlaufenden Mediumkanalwandungen von zwei Mediumkanälen des Profils jeweils in einen durch Wandungen des Anschlussteils/des Verbindungsteils und gegebenenfalls des Profils begrenzten Verbindungskanal münden beziehungsweise dort angeordnet sind, sodass Kühlmedium aus der Durchgangsöffnung in der umlaufenden Mediumkanalwandung des einen Mediumkanals in den Verbindungskanal strömen kann, in dem Verbindungskanal dann zu der Durchgangsöffnung in der umlaufenden Mediumkanalwandung des anderen Mediumkanals fließen kann und durch diese Durchgangsöffnung dann schlussendlich in den anderen Mediumkanal hineinströmen kann.

Nur beispielsweise für den Fall, dass einer der Mediumkanäle beziehungsweise deren zugeordnete umlaufende Mediumkanalwandung im Bereich eines ersten Endes des Profils eine Durchgangsöffnung aufweist, durch die Kühlmedium über das Anschlussteil zuführbar ist, könnte das Kühlmedium dann nach Zuführung diesen Mediumkanal durchströmen, dann im Bereich eines zweiten Endes über den Verbindungskanal zu dem anderen Mediumkanal strömen und schließlich in dem anderen Mediumkanal weitergeführt werden, insbesondere zurück dem ersten Ende. Ausgehend von diesem Grundkonzept, insbesondere der Ausbildung und Nutzung eines solchen Verbindungskanals zwischen Mediumkanälen, das natürlich auch auf eine Gruppe von mehr als zwei Mediumkanälen übertragbar ist, sind diverse verschiedene Varianten denkbar, um die Kühlmediumströmung in dem Kühlbauteil zu gestalten und gezielt zu steuern.

Besonders bevorzugt, aber nicht ausschließlich kann dies insbesondere für beispielsweise zwei benachbarte Mediumkanäle vorgesehen werden, deren umlaufende Mediumkanalwandungen, wie oben bereits ausgeführt, jeweils einen und/oder den gemeinsamen, zwischen ihnen angeordneten, insbesondere sich von einem Ende des Profils bis zum anderen Ende des Profils erstreckenden Wandabschnitt aufweisen.

Weitere Merkmale der vorliegenden Erfindung ergeben sich aus den beigefügten Patentansprüchen, der nachfolgenden Beschreibung bevorzugter Ausführungsbeispiele sowie aus den beigefügten Zeichnungen.

Darin zeigt:

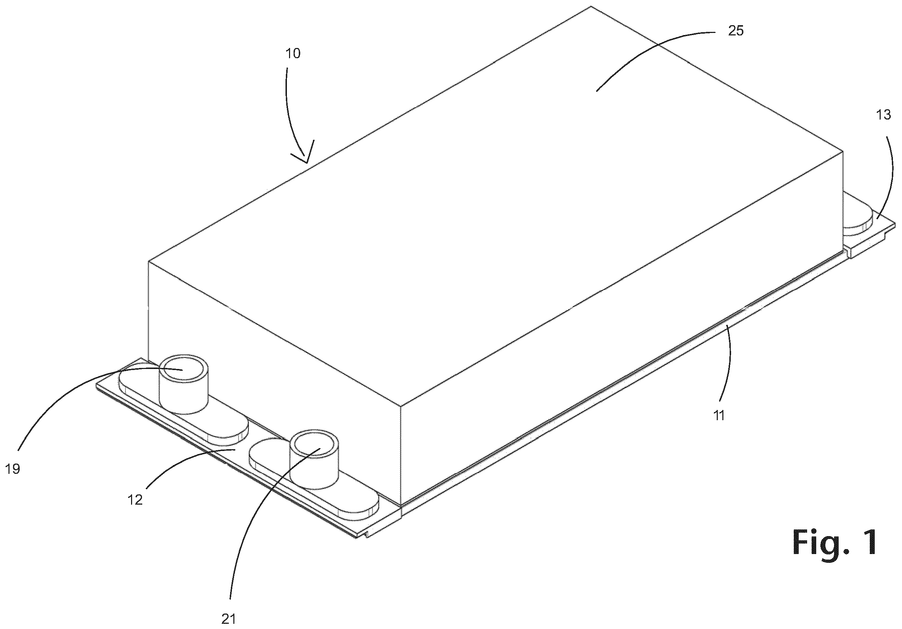

Fig. 1 eine Ausführungsform eines erfindungsgemäßen Kühlbauteils mit Profil, Anschlussteil an einem Ende des Kühlkörpers und Verbindungsteil am anderen Ende des Kühlkörpers, sowie mit einem an dem Kühlbauteil anliegenden, zu kühlenden Gegenstand, in einer Schrägansicht von oben,
Fig. 2 das Kühlbauteil, allerdings ohne zu kühlenden Gegenstand, ebenfalls in Schrägansicht von oben,

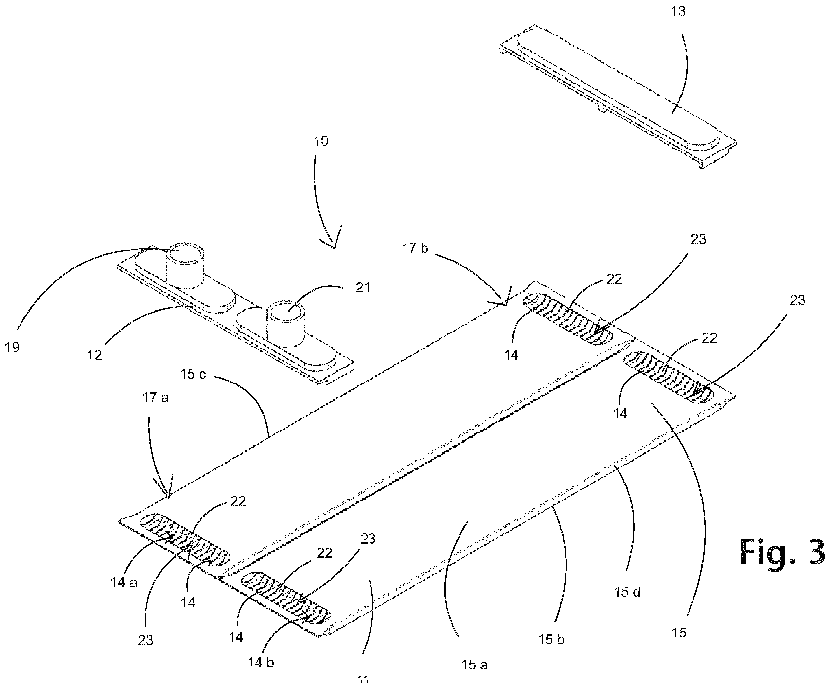

Fig. 3 das Kühlbauteil in einer Explosionsdarstellung,

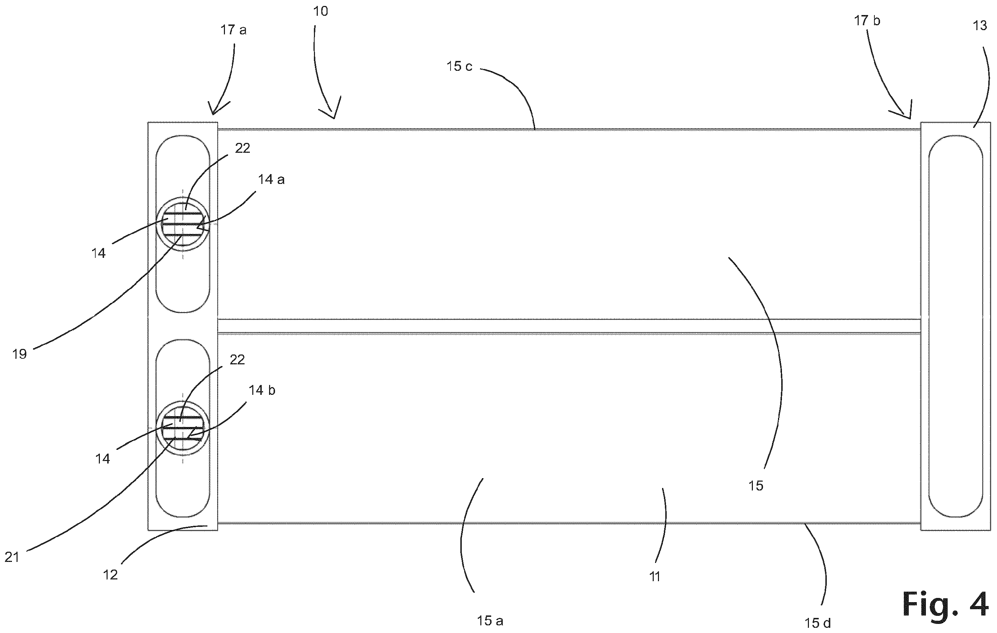

Fig. 4 das Kühlbauteil in einer Draufsicht,

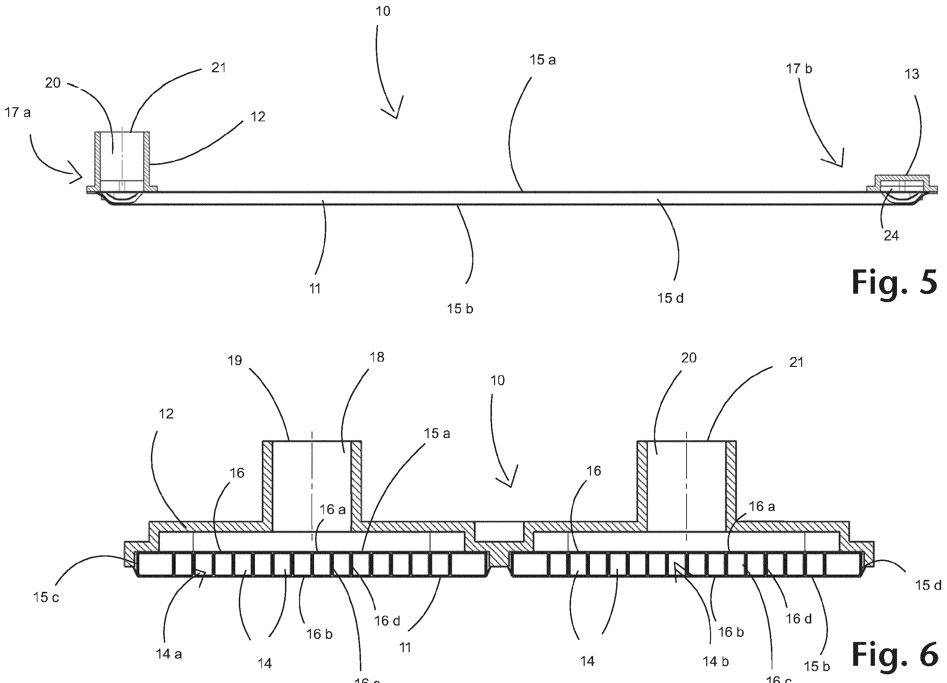

Fig. 5 das Kühlbauteil in einem Längsschnitt,
Fig. 6 das Kühlbauteil in einem Querschnitt im Bereich des Anschlussteils,

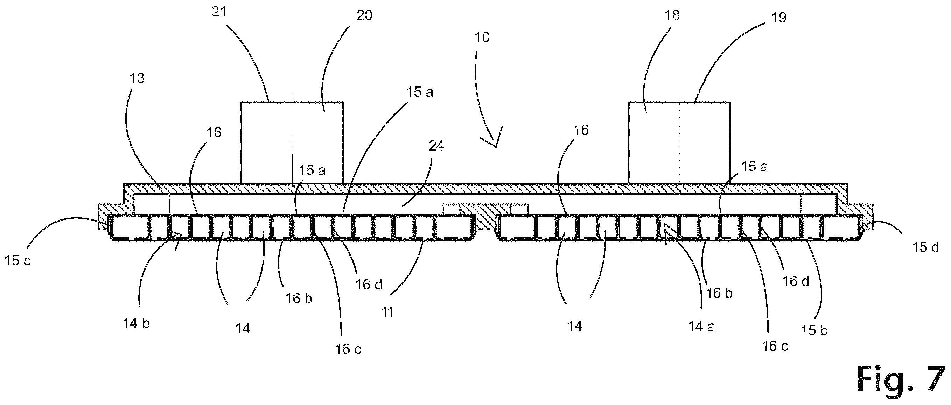

Fig. 7 das Kühlbauteil in einem Querschnitt im Bereich des Verbindungsteils,
Fig. 8 eine alternative Ausgestaltung eines Kühlbauteils,
Fig. 9 eine Explosionsansicht der Ausführungsform gemäß Fig. 8,
Fig. 10 eine weitere Explosionsansicht der Ausführungsform gemäß Fig. 8,
Fig. 11 eine Längsschnitt der Ausführungsformgemäß Fig. 8 mit einer Flussskizze,
Fig. 12 eine weitere alternative Ausgestaltung eines Kühlbauteils,
Fig. 13 eine Explosionsansicht der Ausführungsform gemäß Fig. 11,
Fig. 14 eine weitere Explosionsansicht der Ausführungsform gemäß Fig. 11, und
Fig. 15 eine Schnittansicht der Ausführungsform gemäß Fig. 11.

In den Zeichnungen ist ein Kühlbauteil 10 gezeigt, wie es beispielsweise im Rahmen der Kühlung von Batterie- beziehungsweise von Akkumulatorensystemen von Elektrofahrzeugen verwendet wird, um die jeweiligen Batterien beziehungsweise die einzelnen Zellen zu kühlen. Vorliegend ist beispielhaft eine solche Batterie 25 gezeigt.

Ein solches Kühlbauteil 10 ist dabei in der Regel Bestandteil einer übergeordneten Kühleinrichtung, die dafür sorgt, dass kontinuierlich Kühlmedium durch das Kühlbauteil 10 geführt wird, das dabei Abwärme des zu kühlenden Gegenstands aufnimmt und diese dann abführt.

Die hierfür notwendigen Bauteile der Kühleinrichtung, zum Beispiel eine geeignete Pumpe, Zu- und Ablaufleitungen für das Kühlmedium etc., sind im Stand der Technik bekannt und werden daher nicht näher erläutert.

Im vorliegenden Fall kann das Kühlbauteil 10 beispielsweise im Einsatz mit hier nicht gezeigten identischen weiteren Kühlbauteilen der Kühleinrichtung verbunden werden, die dann zur gleichen Zeit mehrere zu kühlende Gegenstände kühlen können, beispielsweise mehrere Batterien beziehungsweise Batteriezellen.

Das Kühlbauteil 10 verfügt über ein einen Kühlkörper bildendes metallisches Profil 11, vorliegend aus Aluminium, das im Einsatz an dem zu kühlenden Gegenstand anliegt oder zumindest unmittelbar benachbart zu diesem angeordnet wird. Das Profil 11 ist vorliegend einstückig gefertigt und wurde im Aluminium-Extrusionsverfahren hergestellt, ist demnach ein extrudiertes Profil. Naturgemäß kann das metallische Profil beziehungsweise das extrudierte Profil auch aus anderen metallischen Werkstoffen bestehen.

Der Profil 11 ist länglich ausgebildet, vorliegend im Wesentlichen als flacher Quader.

Bezogen auf die Haupterstreckungsrichtung des Kühlbauteils 10 beziehungsweise des Profils 11 ist im Bereich eines Endes 17 a desselben ein Anschlussteil 12 aus Kunststoff angeordnet, über das dem Kühlbauteil 10 Kühlmedium, wie zum Beispiel Kühlwasser oder dergleichen, zugeführt werden kann, das innerhalb einer ersten Gruppe 14 a von länglichen Mediumkanälen 14 dann in der Haupterstreckungsrichtung des Profils 11 beziehungsweise in Längsrichtung zu dem anderen Ende 17 b des Profils 11 geführt wird, dann in einer im Bereich dieses anderen Endes 17 b angeordneten Verbindungsteils 13 umgelenkt wird und in entgegengesetzter Richtung durch eine zweite Gruppe 14 b von länglichen Mediumkanälen 14 in entgegengesetzter Richtung durch den Kühlkörper des Kühlbauteils 10 strömt, bis es wieder das Anschlussteil 12 erreicht und über das Anschlussteil 12 aus dem Kühlbauteil 10 herausgeführt beziehungsweise abgeführt wird.

Auf seinem Weg durch das Profil 11 beziehungsweise durch die Mediumkanäle 14 nimmt das Kühlmedium im Betrieb der Kühleinrichtung beziehungsweise des Kühlbauteils 10 die Abwärme des zu kühlenden Gegenstands, hier der Batterie 25, unter Kühlung des zu kühlenden Gegenstandes auf und transportiert diese ab.

Das Profil 11 verfügt vorliegend über vier Außenwandungen 15, nämlich eine erste großflächige, obere Wandung 15 a, eine zweite großflächige, der oberen Wandung parallel mit Abstand gegenüberliegende, untere Wandung 15 b, sowie zwei parallel zueinander verlaufende, die obere Wandung 15 a und die untere Wandung 15 b jeweils miteinander verbindende Schmalseitenwandungen 15 c beziehungsweise 15 d.

Die länglichen Mediumkanäle 14 sind im Inneren des Profils 11 angeordnet, also im Inneren des durch die Profilaußenwandungen 15 eingeschlossenen Raums. Die Mediumkanäle 14 erstrecken sich dabei parallel zur Haupterstreckungsrichtung des Profils 11 beziehungsweise parallel zu den Schmalseitenwandungen 15 c beziehungsweise 15 d. Bezogen auf einen Querschnitt durch das Profil 11 sind die einzelnen Mediumkanäle 14 in einer Reihe nebeneinander angeordnet.

Jeder längliche Mediumkanal 14 ist des Weiteren an bevorzugt allen seinen Längsseiten, bezogen auf die Haupterstreckungsrichtung des jeweiligen Mediumkanals 14, durch eine umlaufende, durch das Profil 11 gebildete Mediumkanalwandung 16 begrenzt. Die umlaufende Mediumkanalwandung 16 beschreibt dabei einen Hohlquader beziehungsweise - im Querschnitt - ein Rechteck, wobei im Rahmen dieser Anmeldung ein Quadrat als Spezialfall eines Rechtecks definiert wird.

Jede umlaufene Mediumkanalwandung 16 umfasst dabei vorliegend jeweils konkret zwei Paare von sich jeweils mit Abstand gegenüberliegende Wandabschnitte.

Dabei wird jeder Mediumkanal 14 zum einen an zwei gegenüberliegenden vertikalen beziehungsweise senkrecht zu der oberen und unteren großflächigen Wandung 15 a beziehungsweise 15 b verlaufenden Längsseiten, nämlich in Querrichtung beziehungsweise senkrecht zur Haupterstreckungsrichtung des Profils 11, begrenzt durch zwei seitliche, jeweils zueinander parallel in der Haupterstreckungsrichtung des Profils 11 verlaufende, voneinander beabstandete Wandabschnitte 16 a beziehungsweise 16 b. Bei den beiden äußeren Mediumkanälen 14 wird dabei eine dieser Mediumkanalwandungen 16 a und 16 b jeweils durch die jeweilige Profilaußenwandung 15 des Profils 11 gebildet, vorliegend die Schmalseitenwandung 15 c beziehungsweise die Schmalseitenwandung 15 d.

Zum anderen ist jeder längliche Mediumkanal 14 an seinen anderen beiden Längsseiten durch jeweils einen oberen Wandungsabschnitt 16 a und einen unteren Wandungsabschnitt 16 b begrenzt. Dabei wird der jeweilige obere Wandungsabschnitt 16 a jeweils durch einen Teilabschnitt der oberen großflächigen Wandung 15 a des Profils 11 gebildet und der jeweilige untere Wandungsabschnitt 16 b durch einen Teilabschnitt der unteren großflächigen Wandung 15 b.

Jeder Mediumkanal 14 ist im Übrigen vorliegend an seinen Enden des Weiteren nicht offen, sondern an den beiden gegenüberliegenden Profilenden 17 a und 17 b fluiddicht verschlossen. Hierzu wurden im Rahmen der Fertigung des Kühlbauteils 10 dort die sich jeweils zunächst mit Abstand gegenüberliegenden Wandabschnitte 16 a und 16 b der jeweiligen umlaufenden Mediumkanalwandung 16 des jeweiligen Mediumkanals 14 des Profils 11 mittels einer entsprechenden Presseinrichtung aufeinander zu bewegt und fluiddicht miteinander verbunden, nämlich vorliegend unter Entstehung einer Bindenaht verpresst, die anschließend verschweißt oder verlötet wurde.

Was das Anschlussteil 12 betrifft, so weist dieses eine Zulaufkammer 18 mit oberer Zulauföffnung 19 auf, über die dem Kühlbauteil 10 und in der Folge den Mediumkanälen 14 der ersten Gruppe 14 a von Mediumkanälen 14 Kühlmedium zuführbar ist, sowie eine von der Zulaufkammer 18 getrennte Alblaufkammer 20 mit Ablauföffnung 21, über die aus den Mediumkanälen 14 der zweiten Gruppe 14 b von Mediumkanälen Kühlmedium, insbesondere aus dem Anschlussteil 12 beziehungsweise aus dem Kühlbauteil 10, abführbar ist.

Zu diesem Zweck weist vorliegend jede umlaufende Mediumkanalwandung 16 jedes Mediumkanals 14, nämlich vorliegend jeweils der obere Wandabschnitt 16 a derselben, im Bereich des Anschlussteils 12, und zwar vorliegend im Bereich des ersten Endes 17 a des Profils 11, jeweils eine Durchgangsöffnung 22 auf, über die der jeweilige Mediumkanal 14 fluidleitend mit der Zulauföffnung 19 beziehungsweise mit der Ablauföffnung 21 des Anschlussteils 12 verbunden ist. Dies kann insbesondere eine dort beispielsweise mittels eines Bohrwerkzeugs oder eines Lasers eingebrachte Freimachung sein.

Wie erkennbar ist, gehen im vorliegenden Fall die einzelnen Durchgangsöffnungen 22 der umlaufenden Mediumkanalwandungen 16 jeweils in Querrichtung des Profils 11 ineinander über, sind also nicht voneinander beabstandet, sodass sie eine gemeinsame, zusammenhängende, sich insbesondere quer zu den Mediumkanälen 14 erstreckende Profilöffnung 23 in der großflächigen oberen Außenwandung 15 a des Profils 11 bilden. Dies muss aber nicht so sein, die einzelnen Durchgangsöffnungen können auch voneinander beabstandet sein.

Das Anschlussteil 12 ist so auf der oberen Wandung 15 a des Profils 11 platziert, dass die Zulaufkammer 18 und die Ablaufkammer 20 jeweils die zugeordneten Durchgangsöffnungen 22 zur fluidleitenden Verbindung der jeweiligen Mediumkanäle 14 überdeckt beziehungsweise dass die Durchgangsöffnungen 22 in die Zulaufkammer 18 beziehungsweise die Ablaufkammer 20 münden.

Konkret sind die Durchgangsöffnungen 22 der ersten Gruppe 14 a von Mediumkanälen 14 innerhalb der Zulaufkammer 18 so angeordnet, sodass das Kühlmedium unmittelbar aus der Zulaufkammer 18 in und/oder über die Durchgangsöffnungen 22 in die Mediumkanäle 14 dieser ersten Gruppe 14 a fließen kann und die Durchgangsöffnungen der zweiten Gruppe 14 b von Mediumkanälen der Ablaufkammer 20 derart, dass das Kühlmedium unmittelbar aus der Ablaufkammer 20 in und/oder über die Durchgangsöffnungen 22 in die Mediumkanäle 14 dieser zweiten Gruppe 14 b fließen kann.

Was das Verbindungsteil 13 betrifft, so sind auch in dessen Bereich, nämlich im Bereich des zweiten Profilendes 17 b, in die umlaufenden Mediumkanalwandungen 16 der Mediumkanäle 14, nämlich in die jeweiligen oberen Wandabschnitte 16 a, jeweils Durchgangsöffnungen 22 eingebracht, die vorliegend eine durchgehende Profilöffnung 23 bilden. Sämtliche dieser Durchgangsöffnungen 22 sind bei der vorliegenden Ausführungsform durch diesen Umlenkraum 24 überdeckt beziehungsweise die Durchgangsöffnungen 22 münden in diesen.

Kühlmedium, das dort aus den Durchgangsöffnungen 22 der ersten Gruppe 14 a von Mediumkanälen 14 in den Umlenkraum 24 strömt, wird in dem Umlenkraum 24 zu den Durchgangsöffnungen 22 der Mediumkanäle 14 der zweiten Gruppe 14 b von Mediumkanälen 14 umgelenkt, tritt in diese in umgekehrter Richtung ein und strömt dann - in der zweiten Gruppe 14 b von Mediumkanälen - durch das Profil 11 zu dem Anschlussteil 12 zurück.

Wie oben bereits angedeutet - anders als das Profil 11 - bestehen sowohl das Anschlussteil 12 als auch das Verbindungsteil 12 nicht aus Metall beziehungsweise gegebenenfalls aus einer Metalllegierung, sondern aus Kunststoff. Diese Bauteile sind dabei vorliegend jeweils einstückig ausgebildet und als Kunststoff-Spritzgussteil hergestellt, beispielsweise aus Thermoplast.

Zur Verbindung des Anschlussteils 12 und des Verbindungsteils 13 mit dem Profil 11 sind jeweils Verbindungsbereiche beziehungsweise Verbindungsflächen derselben mit Verbindungsbereichen beziehungsweise Verbindungsflächen des Profils 11 fluiddicht verbunden. Dabei weisen vorliegend die Verbindungsflächen des metallischen Profils 11 jeweils durch physikalische und/oder chemische Nano- oder Mikrostrukturierungsverfahren, wie beispielsweise chemischem Ätzen oder Laserstrahlstrukturieren, in die jeweilige Oberfläche eingebrachte, dreidimensionale Nano- und/oder Mikrostrukturen auf.

Jede der in der beschriebenen Weise strukturierten Verbindungsflächen des Profils 11 liegt dabei jeweils einer zugeordneten Verbindungsfläche des Anschlussteils 12 beziehungsweise des Verbindungsteils 13 gegenüber ist und mit dieser verbunden, und zwar beispielsweise unter thermischer Direktfügung verpresst, wie nachfolgend noch näher ausgeführt werden wird.

Die konkrete Herstellung des Kühlbauteils 10 und insbesondere die vorgenannte Verbindung des metallischen Kühlbauteils 10 mit dem aus Kunststoff bestehenden Anschlussteil 12 und mit der aus Kunststoff bestehenden Verbindungsteil 13 erfolgt dabei in besonderer Weise.

Zunächst werden das Profil 11, das Anschlussteil 12 und das Verbindungsteil 13 separat vorgefertigt, vorliegend extrudiert beziehungsweise spritzgegossen.

Dann werden in das Profil 11 durch geeignete Fertigungsverfahren, wie Trennen und/oder Umformen, die Durchgangsöffnungen 22 eingebracht. Dies kann beispielsweise durch Bohren mit einem geeigneten beispielsweise mechanischen Bohrwerkzeug erfolgen oder mittels eines Lasers. Möglich sind auch Stanzen und/oder Biegen und/oder Pressen des Profilmaterials, vorzugsweise mittels Stanz-, Biege-, und/oder Presseinrichtung.

Zudem werden, wie oben bereits detaillierter beschrieben, die zunächst quaderförmigen Enden 17 a und 17 b des Profils 11 unter Verschließen der zuvor stirnseitig offenen Enden der Mediumkanäle 14 des Profils 11 verpresst, sodass jeweils eine Bindenaht entsteht. Diese Bindenaht wird dann verschweißt oder verlötet, um die Fluiddichtigkeit zu garantieren.

In der Regel danach - es versteht sich, dass die Reihenfolge verschiedener Schritte auch verändert werden kann, werden die vorgenannten Bauteile 11, 12, 13 miteinander verbunden. Dies wird nachfolgend exemplarisch an der Verbindung des Anschlussteils 12 mit dem Profil 11 beschrieben. Die Verbindung des Profils 11 mit der dem Verbindungsteils 12 erfolgt in analoger Weise.

Zur Verbindung von Profil 11 und Anschlussteil 12 werden diese beiden Bauteile zunächst relativ zueinander bewegt und ausgerichtet. Beispielsweise, indem das Anschlussteil 12 ortsfest festgehalten wird und das Profil 11 mittels eines geeigneten Förderorgans in Richtung des Anschlussteils 12 bewegt wird. Es versteht sich, dass der Vorgang auch umgekehrt ablaufen kann oder dass beide Bauteile aufeinander zu bewegt werden können.

Im Rahmen der vorgenannten Relativbewegung wird das Profil 11 dann derart relativ zu dem Anschlussteil 12 bewegt, dass dabei die Verbindungsflächen des Profils 11 passgenau platziert werden, sodass jede der Verbindungsflächen des Profils 11 jeweils einer zugeordneten Verbindungsfläche des Anschlussteils 12 gegenüberliegt.

Danach, währenddessen und/oder davor werden dann das metallische Profil 11, zumindest aber die Verbindungsflächen 26 des Profils 11, insbesondere mittels einer im Stand der Technik bekannten Induktionsheizung, auch andere Erwärmungstechniken sind natürlich denkbar, auf eine Temperatur erhitzt oder erwärmt, die mindestens der Erweichungstemperatur des Kunststoffs des Anschlussteils 12 entspricht.

Die Wärme des Profils 11 überträgt sich dann auf das Anschlussteil 12 beziehungsweise dessen Verbindungsflächen, was dann zu einem Aufschmelzen der Verbindungsflächen führt.

Beispielsweise durch ein beziehungsweise gegebenenfalls jeweils ein Pressorgan, wie zum Beispiel eine Pressbacke, die hier nicht gezeigt ist, das jeweils von außen auf die zu verbindenden Wandungen des Anschlussteils 12 drückt, werden dann die jeweiligen Verbindungsflächen gegeneinandergepresst und so fluiddicht verbunden, was als thermische Direktfügung zu verstehen ist.

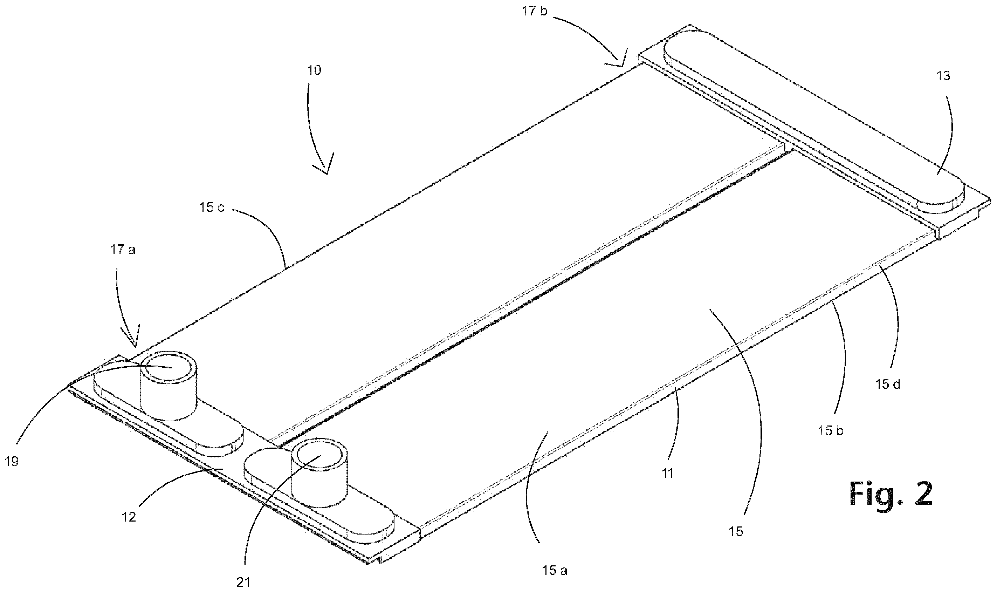

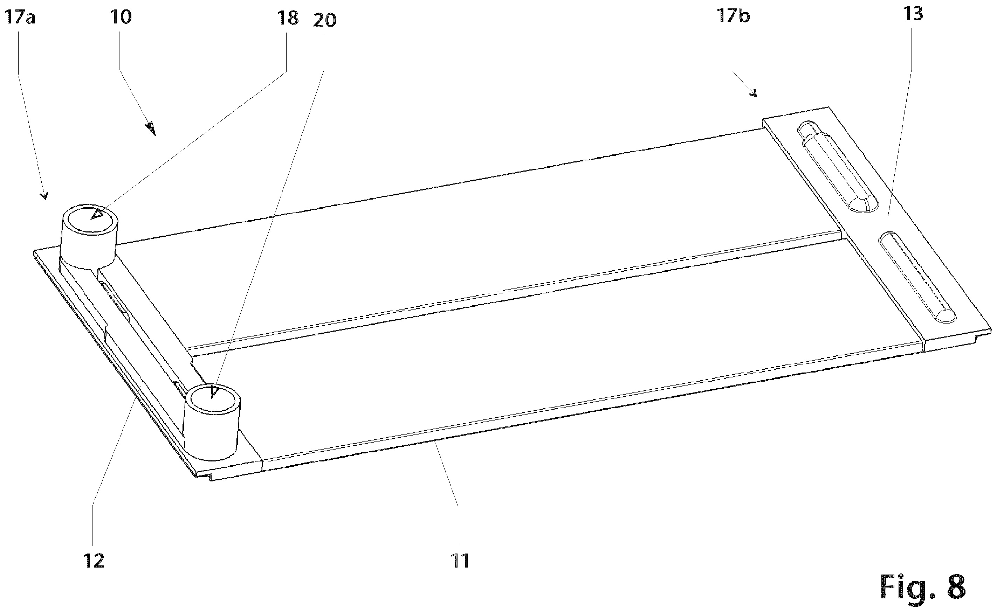

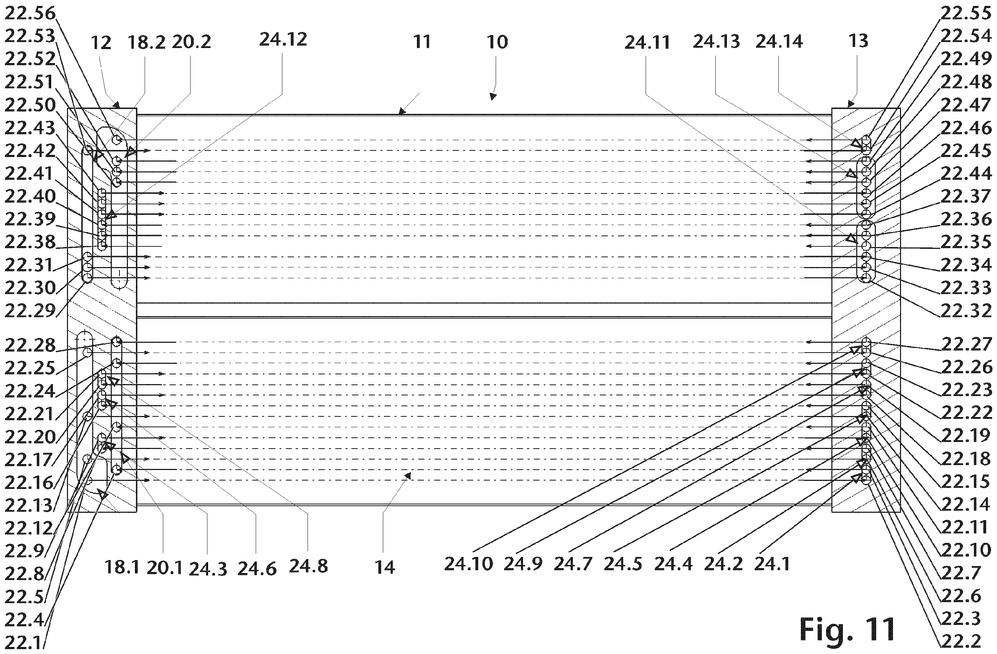

Fig. 8 zeigt eine alternative Ausgestaltung eines Kühlbauteils 10 mit einer Einzelkanalsteuerung. Das Kühlbauteil 10 umfasst ein einen Kühlkörper bildendes metallisches Profil 11, welches wie das vorhergehend beschriebene Profil 11 der Fig. 2 bevorzugt extrudiert ist. Im Bereich eines ersten Endes 17a ist ein Anschlussteil 12 aus Kunststoff angeordnet. Dieses umfasst eine Zulaufkammer 18, über die das Kühlmedium in das Kühlbauteil 10 zuführbar ist. Weiterhin umfasst das Anschlussteil 12 eine Ablaufkammer 20 über die das Kühlmittel aus dem Kühlbauteil 10 abführbar ist. Das zweite Ende 17b des Profils 11 umfasst ein Verbindungsteil 13, mittels dem eine Umleitung des Kühlmittels in Form einer Einzelkanalsteuerung zwischen den Mediumkanälen 14, die in Fig. 11 skizziert sind, erfolgt.

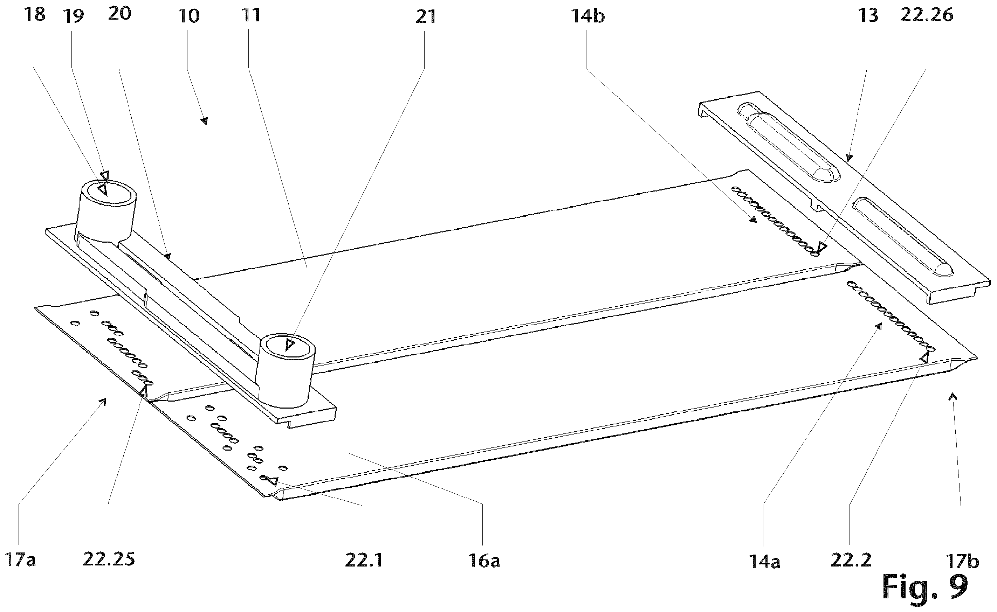

Fig. 9 zeigt eine Explosionsansicht der Aufführungsform nach Fig. 8. Das Profil 11 des Kühlkörpers 10 umfasst eine Vielzahl von Durchgangsöffnungen 22, wobei jeweils zwei Durchgangsöffnung 22 je Mediumkanal 14 an beiden Enden 17a und 17b des Profils 11 angeordnet sind. In Fig. 9 sind exemplarisch die Durchgangsöffnungen 22.1 und 22.2 der Mediumkanäle 14 der ersten Gruppe 14a sowie die Durchgangsöffnungen 22.25 und 22.26 der Mediumkanäle 14 der zweiten Gruppe 14b bezeichnet. Die Durchgangsöffnungen 22 der oberen Mediumkanalwandung 16a sind voneinander beabstandet und gehen nicht ineinander über. Da die Mediumkanäle 14 jeweils an beiden Enden 17a und 17b genau eine Öffnung haben, ist mittels eines entsprechend ausgebildeten Anschlussteiles 12 sowie Verbindungsteiles 13 eine einzelne Ansteuerung der Mediumkanäle 14 mit Kühlmedium möglich. Vorteilhaft kann somit eine Anpassung des Kühlbauteils 10 an die zu erwartende Wärmeenergieabgabe beispielsweise einer Batterie 25 angepasst werden.

Die Durchgangsöffnungen 22 auf am ersten Ende 17a des Profils 11 sind vollständig von dem Anschlussteil 12 überdeckt. Das Anschlussteil 12 weist die Zulaufkammer 18 mit oberer Zulauföffnung 19 auf. Die Zulaufkammer 18 erstreckt sich über beide Gruppen 14a und 14b der Mediumkanäle 14. Das Anschlussteil 12 weist weiterhin die Ablaufkammer 20 mit der Ablauföffnung 21 auf. Die Ablaufkammer 20 erstreckt sich ebenfalls über die beiden Gruppen 14a und 14b der Mediumkanäle 14. Wie aus Fig. 11 ersichtlich, sind die Durchgangsöffnungen 22 am ersten Ende 17a derart angeordnet, dass sie von Zulaufkammer 18, Ablaufkammer 20 und Umlenkräumen überdeckt sind.

Fig. 9 zeigt weiterhin, dass die Durchgangsöffnungen 22 am zweiten Ende 17b des Profils 11 von einem Verbindungsteil 13 vollständig überdeckt sind.

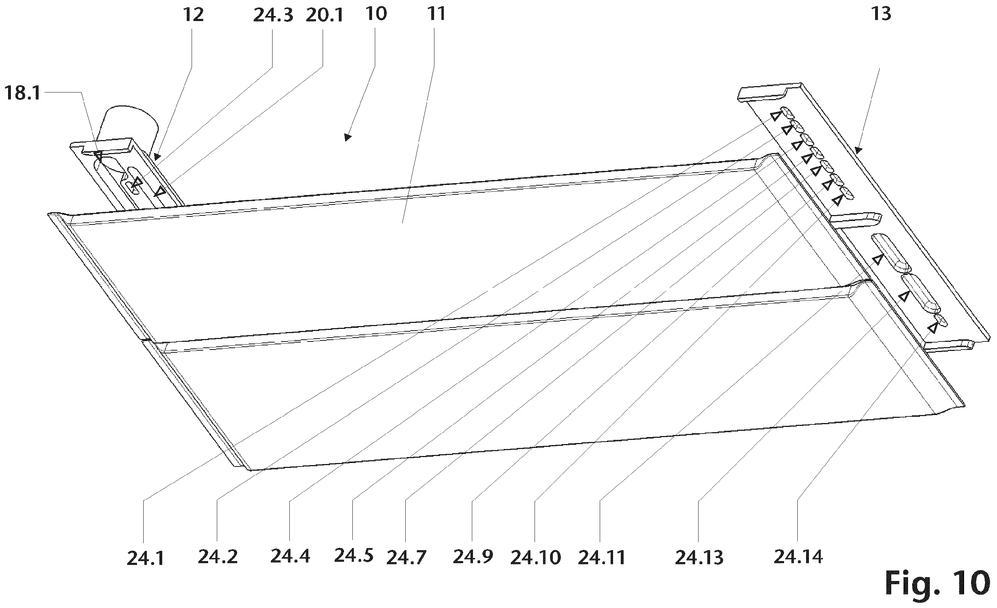

Fig. 10 zeigt eine weitere Explosionsansicht des Kühlbauteils 10 gemäß Fig. 8. Zu erkennen ist das Kühlbauteil 10 in einer perspektivischen Ansicht von unten. Das Anschlussteil 12 umfasst eine Zulaufkammer 18, von der hier ein Teil 18.1 sichtbar ist. Die Ablaufkammer 18.2 ist durch das Profil 11 verdeckt und ist in Fig. 11 ersichtlich. Weiterhin umfasst das Anschlussteil 12 eine Ablaufkammer 20, von der hier der Teil 20.1 sichtbar ist. Die Ablaufkammer 20.2 ist durch das Profil 11 verdeckt und ist in Fig. 11 ersichtlich. Weiterhin umfasst das Anschlussteil 12 Umlenkräume, von denen hier der Umlenkraum 24.3 sichtbar ist. Weitere Umlenkräume des Anschlussteils 12 sind in Fig. 11 ersichtlich.

Fig. 10 zeigt weiterhin, dass das Verbindungsteil 13 Umlenkräume 24.1, 24.2, 24.4, 24.5, 24.7, 24.9, 24.10, 24.11, 24.13 und 24.14 umfasst. In diese münden die in Fig. 11 skizzierten einzelnen Mediumkanäle 14, um das Kühlmedium in weitere Mediumkanäle 14 umzuleiten.

Fig. 11 zeigt das Kühlbauteil 10 in einer Aufsicht, wobei das Anschlussteil 5 und das Verbindungsteil 13 in einer Ebene parallel zum Kühlkörper längs geschnitten sind. Das Anschlussteil 12 weist die Zulaufkammer 18 auf, die in der Schnittansicht in zwei Teile 18.1 und 18.2 aufgeteilt ist. Die Zulaufkammerteile 18.1 und 18.2 sind kommunizierend miteinander verbunden. Die Ablaufkammer 20 ist ebenfalls in der Schnittansicht in zwei Teile 20.1 und 20.1 aufgeteilt. Ablaufkammerteile 20.1 und 20.2 sind kommunizierend miteinander verbunden.

Die Zulaufkammer 18.1 mündet durch die Durchgangsöffnungen 22.1, 22.5, 22.13 und 22.25 in unterschiedliche Mediumkanäle 14. Die Mediumkanäle 14 sind der Übersichtlichkeit halber in der Fig. 11 nicht einzeln mit Bezugszeichen versehen, jedoch durch Pfeile, die die Flussrichtung des Kühlmediums andeuten, skizziert. Das Kühlmittel, das durch die Durchgangsöffnung 22.1 in einen Mediumkanal eingespeist wird, wird durch die Durchgangsöffnung 22.1 in dem Umlenkraum 24.1 gespeist und von dort über die Durchgangsöffnungen 22.3 in den nebenliegenden Mediumkanal geführt und schließlich in die Ablaufkammer 20.1 eingespeist. Ausgehend von der Zulaufkammer 18.1 wird weiterhin das Kühlmittel durch die Durchgangsöffnung 22.5 in einen Mediumkanal 14 eingespeist und weiter durch die Durchgangsöffnung 22.6 dem Umlenkraum 24.2 des Verbindungsteils 13 und von dort durch die Durchgangsöffnung 22.7 in einen weiteren Mediumkanal 14 geleitet. Im Anschlussteil 12 ist ein Umlenkraum 24.3 angeordnet, in dem das Kühlmedium von der Durchgangsöffnung 22. 8 über die Durchgangsöffnung 22.9 in einen weiteren Mediumkanal 14 geleitet wird. Der Umlenkraum 24.4 leitet daraufhin das Kühlmedium von der Durchgangsöffnung 22.10 zur Durchgangsöffnung 22.11 in den nebenliegenden Mediumkanal 14, der schließlich über die Durchgangsöffnung 22.12 in der Ablaufkammer 20.1 mündet.

Weiterhin wird Kühlmedium von der Zulaufkammer 18.1 über die Durchgangsöffnung 22.13 in einen Mediumkanal 14 geleitet. Das Kühlmedium strömt von dort aus durch die Durchgangsöffnung 22.14 in den Umlenkraum 24.5 und von dort durch die Durchgangsöffnung 22.15 in den nebenliegenden Medienkanal 14. Die Durchgangsöffnung 22.16 leitet das Kühlmedium in den Umlenkraum 22.6 und von dort über die Durchgangsöffnung 22.17 in den benachbarten Mediumkanal 14. Das Kühlmedium wird weiterhin durch die Durchgangsöffnung 22.18 in den Umlenkraum 22.7 geleitet und von dort über die Durchgangsöffnung 22.19 in den benachbarten Mediumkanal 14. Durch die Durchgangsöffnungen 22.20 und 22.21 wird das Kühlmedium mittels des Umlenkraumes 24.8 in einen weiteren Mediumkanal 14 geleitet, der mit der Durchgangsöffnung 22.22 in dem Umlenkraum 24.9 mündet. Von dort aus wird das Kühlmedium über die Durchgangsöffnung 22.23 in einen Mediumkanal 14 geleitet und mündet schließlich über die Durchgangsöffnung 22.24 in der Ablaufkammer 20.1.

Von der Zulaufkammer 18.1 fließt das Kühlmedium des Weiteren durch die Durchgangsöffnung 22.25 in einen weiteren Mediumkanal 14 der mit der Durchgangsöffnung 22.26 in dem Umlenkraum 24.10 mündet. Von dort wird das Kühlmedium durch die Durchgangsöffnung 22.27 in den Mediumkanal 14 zurück durch die Durchgangsöffnung 22.28 in die Ablaufkammer 20.1 geleitet.

Das Kühlmedium wird weiterhin von der Zulaufkammer 18.1 durch die Durchgangsöffnung 22.25 in einen Mediumkanal 14 geleitet und von dort durch die Durchgangsöffnung 22.26 in den Umlenkraum 24.10. Von dort wird das Kühlmedium durch die Durchgangsöffnung 22.27 in den benachbarten Mediumkanal 14 und dann durch die Durchgangsöffnung 22.28 in die Ablaufkammer 20.1 geleitet.

Es können je nach zu erwartender Wärmeabgabe beziehungsweise Kühlbedarf mittels der gezeigten Einzelkanalsteuerung aber nicht nur jeder Mediumkanal 14 einzeln angesteuert werden, sondern auch mehrere Mediumkanäle 14 gleichzeitig. So werden ausgehend von der Zulaufkammer 18.2 drei Mediumkanäle 14 durch die Durchgangsöffnungen 22.29, 22.30 und 22.31 gespeist. Die Mediumkanäle 14 münden mit den Durchgangsöffnungen 22.32, 22.33 und 22.34 in dem Umlenkraum 24.11, über den das Kühlmedium durch die Durchgangsöffnungen 22.35, 22.36 und 22.37 in weitere drei Mediumkanäle 14 weiter geleitet wird. Ein weiterer Umlenkraum 24.12 in dem Anschlussteil 12 empfängt das Kühlmedium durch die Durchgangsöffnungen 22.28, 22.39 und 22.40 und leitet dieses in drei nebenliegende Mediumkanäle 14 über die Durchgangsöffnungen 22.41, 22.42 und 22.43 ein. Im Umlenkraum 24.13 wird das Kühlmedium von den Durchgangsöffnungen 22.44, 22.45 und 22.46 durch die Durchgangsöffnungen 22.47, 22.48 und 22.49 in weitere Mediumkanäle 14 geleitet. Diese Mediumkanäle 14 münden über die Durchgangsöffnungen 22.50, 22.51 und 22.52 in der Ablaufkammer 20.2. Weiterhin fließt das Kühlmedium aus der Zulaufkammer 18.2 durch die Durchgangsöffnungen 22.53 und 22.54 in den Umlenkraum 24.14 und von dort durch die Durchgangsöffnungen 22.55 und 22.56 in die Ablaufkammer 20.2.

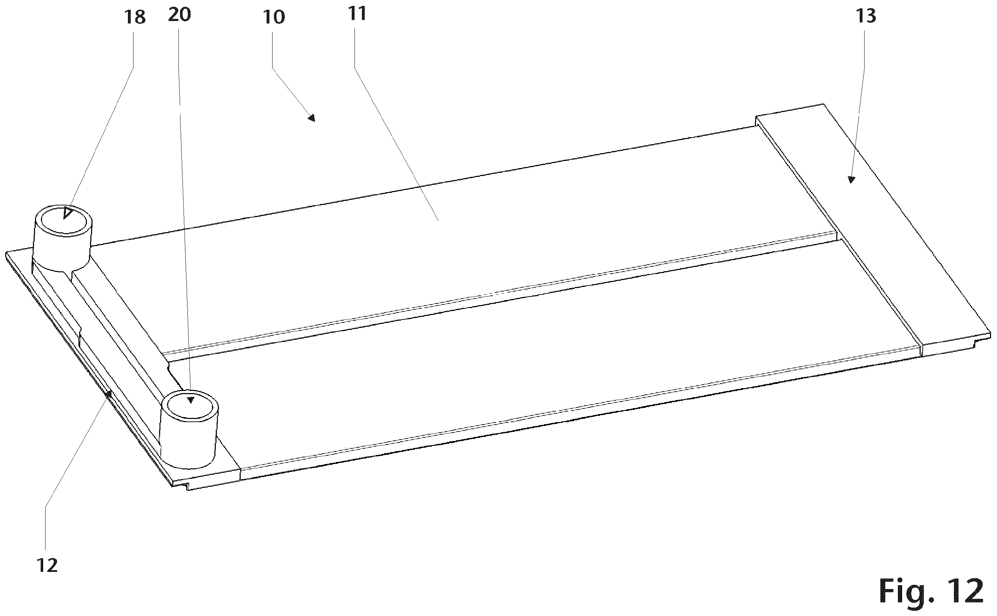

Fig. 12 zeigt eine weitere alternative Ausgestaltung eines Kühlbauteils 10 mit Einzelkanalsteuerung. Zu erkennen ist das Profil 11 sowie das Anschlussteil 12 mit der Zulaufkammer 18 und der Ablaufkammer 20 sowie das Verbindungsteil 13.

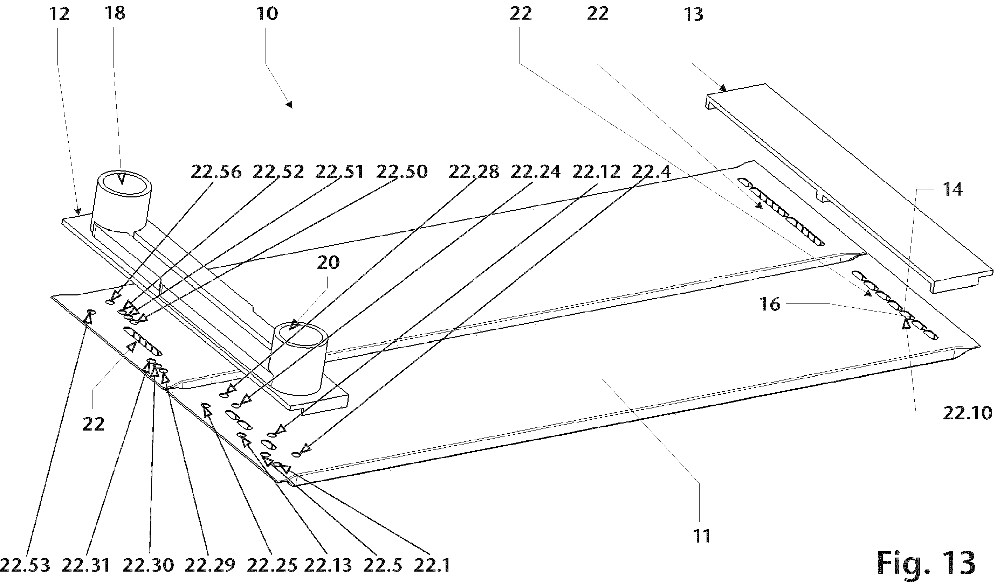

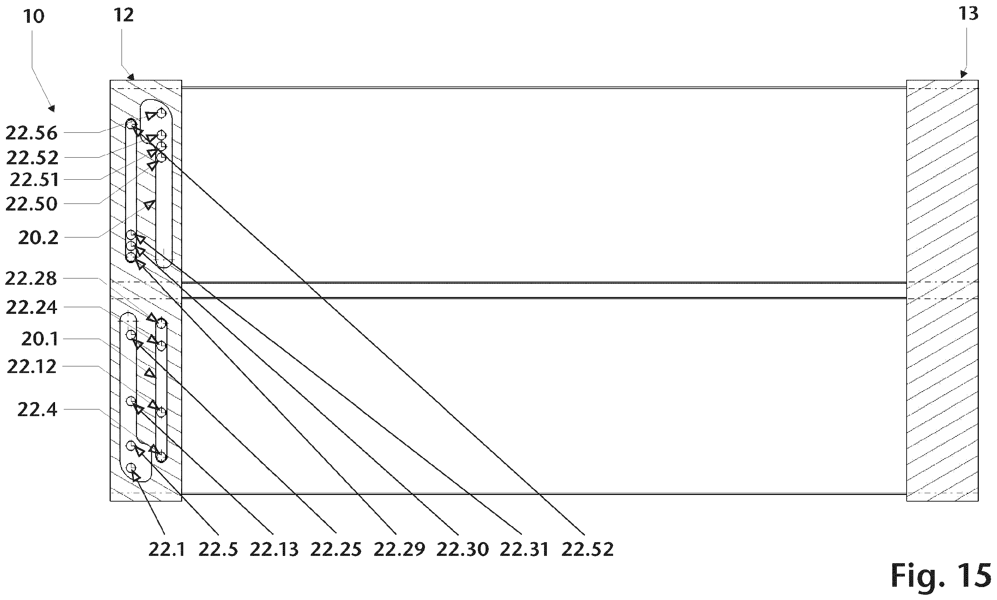

Fig. 13 zeigt eine Explosionsansicht des Kühlbauteiles 10 gemäß Fig. 12. Das Profil 11 umfasst eine Vielzahl von Durchgangsöffnungen 22, wobei die Durchgangsöffnungen 22.1, 22.5, 22.13, 22.25, 22.29.22.30, 22.31 und 22.53, die der hier nicht sichtbaren Zulaufkammer 18 zugeordnet sind, einzeln ausgestaltet und nur über die Zulaufkammer 18 verbunden sind, was in Fig. 15 . zu erkennen ist. Auch die Durchgangsöffnungen 22.4, 22.12, 22.24, 22.28, 22.50, 22.51, 22.52 und 22.56 sind einzeln ausgestaltet und nur über die Ablaufkammer 20 verbunden, was ebenfalls in Fig. 15 zu erkennen ist. Die übrigen Durchgangsöffnungen 22, die hier der Übersichtlichkeit halber nicht alle mit Bezugszeichen versehen sind, sind insbesondere diejenigen Durchgangsöffnungen 22, die in der vorher beschriebenen Ausgestaltung in einem Umlenkraum 13 münden. Das Anschlussteil 12 und das Verbindungsteil 13 umfassen jedoch in dieser Ausführungsform keine Umlenkräume. Vielmehr sind gemeinsame Wandabschnitte der umlaufenden Mediumkanalwandung 16 der beiden benachbarten Mediumkanäle 14 in mindestens einem Bereich unterbrochen, was beispielhaft bei der Durchgangsöffnung 22.10 zu erkennen ist. Derart kann Kühlmedium von dem einen zu dem anderen Mediumkanal 14 strömen. In dieser Ausgestaltung dichtet das Verbindungsteil 13 die Mediumkanäle 14 im Bereich der Durchgangsöffnungen 22 am zweiten Ende 17b nach oben hin ab.

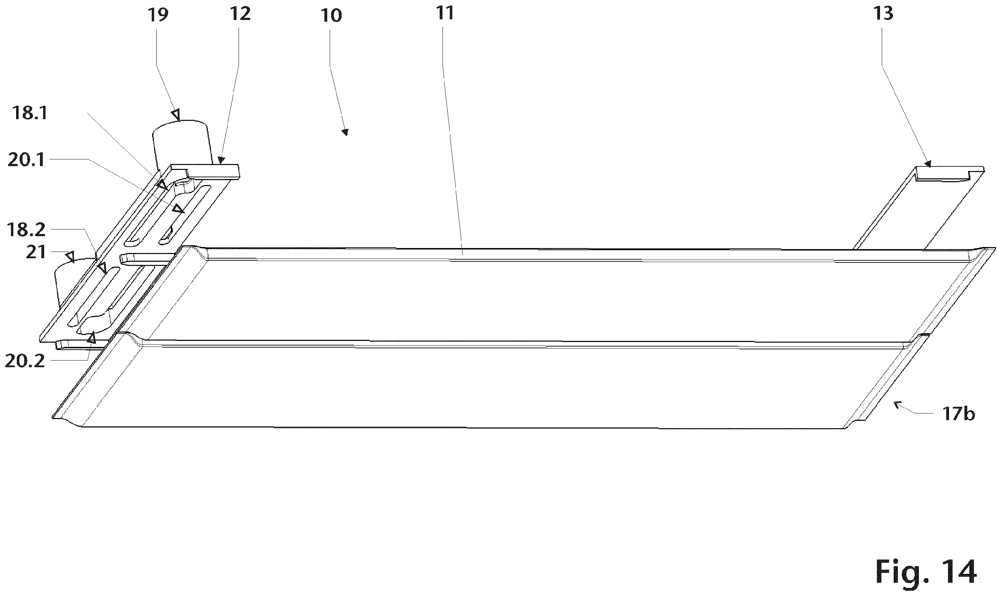

Fig. 14 zeigt eine Explosionsansicht des Kühlbauteils 10 von unten. Das Anschlussteil 12 umfasst zwei Zulaufkammern 18.1 und 18.2, die kommunizierend miteinander und mit der Zulauföffnung 19 verbunden sind. Weiterhin umfasst das Anschlussteil 12 zwei Ablaufkammern 20.1 und 20.2, die kommunizierend miteinander und mit der Ablauföffnung 21 verbunden sind. Das Anschlussteil 12 umfasst keine Umlenkräume. Vielmehr ist dieses auf der dem Profil 11 zugewandten Seite im Bereich der Durchgangsöffnungen 22, die in Fig. 13 zu sehen sind und deren gemeinsame Wandabschnitte der umlaufenden Mediumkanalwandung 16 in mindestens einem Bereich unterbrochen sind, eben ausgestaltet. Somit kann das Anschlussteil 12 genau diese Durchgangsöffnungen 22 nach oben hin abdichten.

Weiterhin ist Fig. 14 das Verbindungsteil 13 zu entnehmen, dass keinerlei Kammern oder Umlenkräume umfasst. Vielmehr werden durch das Verbindungsteil 13 sämtliche Durchgangsöffnungen 22, die Fig. 13 zu sehen sind, an dem Ende 17b nach oben hin abgedichtet. Die Umlenkräume werden in dieser Ausführungsform nicht benötigt, da gemeinsame Wandabschnitte der umlaufenden Mediumkanalwandung 16 in mindestens einem Bereich unterbrochen sind, wodurch das Kühlmedium zwischen den Mediumkanälen 14, die die gemeinsame Mediumkanalwandung 16 aufweisen, strömen kann.

Fig. 15 zeigt das Kühlbauteil 10 gemäß Fig. 12 in einer Aufsicht, wobei das Anschlussteil 12 und das Verbindungsteil 13 in einer Ebene parallel zum Kühlkörper längs geschnitten sind. Das Anschlussteil 12 weist die Zulaufkammer 18 auf, die in der Schnittansicht in zwei Teile 18.1 und 18.2 aufgeteilt ist. Die Zulaufkammerteile 18.1 und 18.2 sind kommunizierend miteinander verbunden. Die Zulaufkammer 18.1, 18.2 mündet durch die Durchgangsöffnungen 22.1, 22.5, 22.13, 22.25, 22.29, 22.30, 22.31 und 22.53 in unterschiedliche Mediumkanäle 14, die hier nicht dargestellt sind.

Die Ablaufkammer 20 ist ebenfalls in der Schnittansicht in zwei Teile 20.1 und 20.1 aufgeteilt. Ablaufkammerteile 20.1 und 20.2 sind kommunizierend miteinander verbunden. Einzelne Medienkanäle 14 münden über die Durchgangsöffnungen 22.4, 22.12, 22.24, 22.28, 22.50, 22.51, 22.52 und 22.56 in die Ablaufkammer 20.1, 20.2.

Weder Anschlussteil 12 noch Verbindungsteil 13 umfassen einen Umlenkraum, da mittels der Wandunterbrechungen das Kühlmedium von zwischen den Mediumkanälen 14 strömen kann.

Vorteilhaft können mit der Einzelkanalsteuerung die Mediumkanäle 14 derart mit Kühlmedium angesteuert werden, wie es eine zu erwartende Verteilung der Wärmeabgabe einer Wärmequelle erfordert.

### Bezugszeichenliste

| | | | |
|---|---|---|---|
| 10 | Kühlbauteil | 22 | Durchgangsöffnung |
| 11 | Profil | 22.1. bis 22.56 | Durchgangsöffnung |
| 12 | Anschlussteil | 23 | Profilöffnung |
| 13 | Verbindungsteil | 24 | Umlenkarm |
| 14 | Mediumkanal | 24.1 bis 24.14 | Umlenkarm |
| 14 a | erste Gruppe von Mediumkanälen | 25 | Batterie |
| 14 b | zweite Gruppe von Mediumkanälen | | |
| 15 | Außenwandungen | | |
| 15 a | erste großflächige Wandung | | |
| 15 b | zweite großflächige Wandung | | |
| 15 c | Schmalseitenwandung | | |
| 15 d | Schmalseitenwandung | | |
| 16 | umlaufende Mediumkanalwandung | | |
| 16 a | oberer Wandabschnitt | | |
| 16 b | unterer Wandabschnitt | | |
| 16 c | seitlicher Wandabschnitt | | |
| 16 d | seitlicher Wandabschnitt | | |
| 17 a | Profilende | | |
| 17 b | Profilende | | |
| 18 | Zulaufkammer | | |
| 18.1 | Zulaufkammer | | |
| 18.2 | Zulaufkammer | | |
| 19 | Zulauföffnung | | |
| 20 | Ablaufkammer | | |
| 20.1 | Ablaufkammer | | |
| 20.2 | Ablaufkammer | | |
| 21 | Ablauföffnung | | |

## Patentansprüche

1. Kühlbauteil zum Kühlen von Gegenständen mit mindestens einem einen Kühlkörper bildenden metallischen Profil (11), wobei der Profil (11) mehrere parallele, längliche Mediumkanäle (14) zum Durchfluss von Kühlmedium aufweist, von denen jeder jeweils von einer umlaufenden, durch das Profil (11) gebildeten Mediumkanalwandung (16) begrenzt wird, und mit einem mit dem Profil (11) fluiddicht verbundenen ersten Anschlussteil (12) aus Kunststoff mit Zulauf- und/oder Ablauföffnung, über die dem Kühlbauteil Kühlmedium zuführbar ist bzw. über die Kühlmedium aus dem Kühlbauteil abführbar ist, **dadurch gekennzeichnet, dass** die umlaufende Mediumkanalwandung (16) mindestens eines der parallelen Mediumkanäle (14), im Bereich des ersten Anschlussteils (12) eine Durchgangsöffnung (22; 22.1 bis 22.56) in Form einer in die umlaufende Mediumkanalwandung (16) eingebrachten Freimachung aufweist, über die der Mediumkanal (14) fluidleitend mit der Zulauf- bzw. mit der Ablauföffnung des ersten Anschlussteils (12) verbunden ist, wobei das Profil (11) ausgebildet ist mit einer ersten großflächigen Außenseite und mit einer von dieser beabstandeten zweiten großflächigen Außenseite, wobei die oder jede im Bereich des ersten Anschlussteils (12) angeordnete Durchgangsöffnung (22; 22.1 bis 22.56) an der ersten oder der zweiten großflächigen Außenseite des Profils (11) angeordnet ist.

2. Kühlbauteil gemäß Anspruch 1, **dadurch gekennzeichnet, dass** die parallelen Mediumkanäle (14) an ihren gegenüberliegenden Enden stirnseitig verschlossen sind, indem sich gegenüberliegende Abschnitte der jeweiligen umlaufenden Mediumkanalwandung (16) des jeweiligen Mediumkanals (14) fluiddicht miteinander verbunden sind, vorzugsweise kraft- und/oder stoffschlüssig, besonders bevorzugt unter Verpressung und/oder Verschweißung der sich gegenüberliegenden Abschnitte.

3. Kühlbauteil gemäß Anspruch 1 oder 2, **dadurch gekennzeichnet, dass** die Durchgangsöffnungen (22; 22.1 bis 22.56) der umlaufenden Mediumkanalwandungen (16) einer Gruppe von nebeneinander angeordneten Mediumkanälen (14) eine gemeinsame, zusammenhängende, insbesondere sich quer zu den Mediumkanälen (14) erstreckende Profilöffnung (23) bilden.

4. Kühlbauteil gemäß Anspruch 1 oder 2, **dadurch gekennzeichnet, dass** die Durchgangsöffnungen (22; 22.1 bis 22.56) der umlaufenden Mediumkanalwandungen (16) einer Gruppe von jeweils nebeneinander angeordneten Mediumkanälen (14) des Profils (11) jeweils durch von dem Profil (11), insbesondere den umlaufenden Mediumkanalwandungen (16) gebildeten, vorzugsweise parallelen Materialstegen voneinander getrennt sind.

5. Kühlbauteil gemäß einem oder mehreren der vorhergehenden Ansprüche, **dadurch gekennzeichnet, dass** die Durchgangsöffnungen (22; 22.1 bis 22.56) der umlaufenden Mediumkanalwandungen (16) einer Gruppe von jeweils nebeneinander angeordneten Mediumkanälen (14) des Profils (11) in einer gemeinsamen (ungekrümmten) Ebene angeordnet sind.

6. Kühlbauteil gemäß einem oder mehreren der vorhergehenden Ansprüche, **dadurch gekennzeichnet, dass** die umlaufenden Mediumkanalwandungen (16) von zwei benachbarten Mediumkanälen (14) einen gemeinsamen, zwischen den Mediumkanälen (14) angeordneten, insbesondere sich von einem Ende des Profils bis zum anderen Ende des Profils erstreckenden Wandabschnitt aufweisen, an den die beiden benachbarten Mediumkanäle (14) jeweils angrenzen.

7. Kühlbauteil gemäß einem oder mehreren der vorhergehenden Ansprüche, **dadurch gekennzeichnet, dass** die umlaufenen Mediumkanalwandungen einer ersten Teilgruppe der parallel verlaufenden Mediumkanälen (14) jeweils eine Durchgangsöffnung (22; 22.1 bis 22.56) aufweisen, über die der jeweiligen Mediumkanal (14) fluidleitend mit der Zulauf- bzw. der Ablauföffnung des ersten Anschlussteils (12) verbunden ist, und dass die umlaufenden Mediumkanalwandungen einer zweiten Teilgruppe von Mediumkanälen jeweils eine Durchgangsöffnung (22; 22.1 bis 22.56) aufweisen, über die der jeweilige Mediumkanal (14) nicht fluidleitend mit der Zulauf- bzw. der Ablauföffnung des ersten Anschlussteils (12) verbunden ist, sondern die, insbesondere durch das erste Anschlussteil (12), nach außen hin fluiddicht verschlossen ist.

8. Kühlbauteil gemäß einem oder mehreren der vorhergehenden Ansprüche, **dadurch gekennzeichnet, dass** das Profil (11) einstückig ausgebildet ist.

9. Kühlbauteil gemäß einem oder mehreren der vorhergehenden Ansprüche, **dadurch gekennzeichnet, dass** das Profil (11) mit der ersten großflächigen, insbesondere ebenen, gebogenen oder gewellten Außenseite, mit der von dieser beabstandeten, zu dieser insbesondere parallel verlaufenden, zweiten großflächigen, insbesondere ebenen, gebogenen oder gewellten Außenseite und mit zwei voneinander beabstandeten, die erste und die zweite großflächige Außenseite jeweils miteinander verbindenden, insbesondere ebenen, gebogenen oder gewellten schmalen Außenseiten, ausgebildet ist.

10. Kühlbauteil gemäß einem oder mehreren der vorhergehenden Ansprüche, **dadurch gekennzeichnet, dass** das erste Anschlussteil (12) und die oder jede im Bereich des ersten Anschlussteils (12) angeordnete Durchgangsöffnung (22; 22.1 bis 22.56) im Bereich eines ersten Endes des Profils (11) angeordnet ist, insbesondere mit Abstand zu diesem, oder in einem mittigen Bereich des Profils (11).

11. Kühlbauteil gemäß einem oder mehreren der vorhergehenden Ansprüche, **dadurch gekennzeichnet, dass** das erste Anschlussteil (12) eine die Zulauföffnung (19) umfassende Zulaufkammer (18; 18.1, 18.2) aufweist, in die die Durchgangsöffnung (22; 22.1 bis 22.56) der umlaufenden Mediumkanalwandung (16) des (ggf. jeweiligen) Mediumkanals (14) mündet, über die der Mediumkanal (14) fluidleitend mit der Zulauföffnung verbunden ist, und/oder dass das erste Anschlussteil (12) eine insbesondere von der Zulaufkammer (18; 18.1, 18.2) getrennte, die Ablauföffnung (21) umfassende Ablaufkammer (20; 20.1, 20.2) aufweist, in die die Durchgangsöffnung (22; 22.1 bis 22.56) der umlaufenden Mediumkanalwandung (16) des (ggf. jeweiligen) Mediumkanals (14) mündet, über die der Mediumkanal (14) fluidleitend mit der Ablauföffnung verbunden ist.

12. Kühlbauteil gemäß einem oder mehreren der vorhergehenden Ansprüche, **dadurch gekennzeichnet, dass** die umlaufende Mediumkanalwandung (16) des (ggf. jeweiligen) Mediumkanals (14), vorzugsweise die jeweilige umlaufende Mediumkanalwandung (16) der mehreren oder sämtlicher Mediumkanäle (14), im Bereich eines zweiten mit dem Profil (11) fluiddicht verbundenen Anschlussteils aus Kunststoff eine weitere Durchgangsöffnung (22; 22.1 bis 22.56) aufweist, insbesondere eine in die umlaufende Mediumkanalwandung (16) eingebrachte Freimachung, über die der Mediumkanal (14) fluidleitend mit einer Zulauf- oder Ablauföffnung des weiteren Anschlussteils (12) verbunden ist.

13. Kühlbauteil gemäß einem oder mehreren der vorhergehenden Ansprüche, **dadurch gekennzeichnet, dass** die umlaufende Mediumkanalwandung (16) des (ggf. jeweiligen) Mediumkanals (14), vorzugsweise die jeweilige umlaufende Mediumkanalwandung (16) der mehreren oder sämtlicher Mediumkanäle (14), im Bereich eines fluiddicht mit dem Profil (11) verbundenen Verbindungsteils aus Kunststoff eine weitere Durchgangsöffnung (22; 22.1 bis 22.56) aufweist, über die dieser Mediumkanal (14) fluidleitend mit einem Innenraum des Verbindungsteils verbunden ist, wobei dieser Innenraum wiederum mit mindestens einem weiteren der parallelen Mediumkanäle (14) fluidleitend verbunden ist über eine im Bereich des Verbindungsteils angeordnete Durchgangsöffnung (22; 22.1 bis 22.56) in der umlaufenden Mediumkanalwandung (16) des weiteren Mediumkanals (14).

14. Kühlbauteil gemäß einem oder mehreren der vorhergehenden Ansprüche 12 oder 13, **dadurch gekennzeichnet, dass** das zweite Anschlussteil oder das Verbindungsteil (13) sowie die oder jede im Bereich des zweiten Anschlussteils bzw. des Verbindungsteils angeordnete Durchgangsöffnung (22; 22.1 bis 22.56) mit Abstand im Bereich eines dem ersten Ende gegenüberliegenden zweiten Ende des Profils (11) angeordnet ist, und zwar mit Abstand zu dem zweiten Ende, oder dass das zweite Anschlussteil zusammen mit dem ersten Anschlussteil (12) in einem mittigen Bereich des Profils (11) angeordnet ist.

15. Kühlbauteil gemäß einem oder mehreren der vorhergehenden Ansprüche, mindestens gemäß Anspruch 6, **dadurch gekennzeichnet, dass** der gemeinsame Wandabschnitt der umlaufenden Mediumkanalwandung (16) der beiden benachbarten Mediumkanäle (14) in mindestens einem Bereich, insbesondere in mindestens einem Endbereich der benachbarten Mediumkanäle (14), unterbrochen ist oder eine Verbindungsöffnung aufweist, sodass dort Kühlmedium von dem einen zu dem anderen Mediumkanal (14) strömen kann.

16. Kühlbauteil gemäß Anspruch 15, **dadurch gekennzeichnet, dass** der gemeinsame Wandabschnitt die beiden Mediumkanäle (14) außerhalb des oder jedes Bereichs, in dem der Wandabschnitt unterbrochen ist oder außerhalb der oder jeder Verbindungsöffnung fluiddicht voneinander trennt.

17. Kühlbauteil gemäß einem oder mehreren der vorhergehenden Ansprüche, **dadurch gekennzeichnet, dass** das erste Anschlussteil (12) und/oder das zweite Anschlussteil und/oder das Verbindungsteil (13), insbesondere ein oder mehrere Wandungen desselben, derart ausgebildet ist, dass es mindestens einen Mediumkanal (14), insbesondere einen Mediumkanal (14), der in seiner umlaufenden Mediumkanalwandung (16) im Bereich des ersten Anschlussteils (12) oder des zweiten Anschlussteils oder des Verbindungsteils (13) eine - vorzugsweise durch Trennen und/oder Umformen eingebrachte - Durchgangsöffnung (22; 22.1 bis 22.56) aufweist, von der Zulaufkammer (18; 18.1, 18.2) oder der Ablaufkammer (20; 20.1, 20.2) des ersten Anschlussteils (12) bzw. des zweiten Anschlussteils trennt oder von dem Innenraum des Verbindungsteils (13), sodass kein Kühlmedium zwischen dieser Durchgangsöffnung (22; 22.1 bis 22.56) einerseits und der Zulaufkammer (18; 18.1, 18.2) bzw. der Ablaufkammer (20; 20.1, 20.2) bzw. dem Innenraum andererseits strömen kann.

18. Kühlbauteil gemäß einem oder mehreren der vorhergehenden Ansprüche, **dadurch gekennzeichnet, dass** das erste Anschlussteil (12) und/oder das zweite Anschlussteil und/oder das Verbindungsteil (13), insbesondere ein oder mehrere Wandungen desselben, derart ausgebildet ist, dass es - unter Ausbildung eines Verbindungskanals zwischen diesen - mindestens zwei vorzugsweise benachbarte Mediumkanäle (14), die jeweils in deren umlaufender Mediumkanalwandung (16) im Bereich des ersten Anschlussteils (12) oder des zweiten Anschlussteils oder des Verbindungsteils (13) eine - vorzugsweise durch Trennen und/oder Umformen eingebrachte - Durchgangsöffnung (22; 22.1 bis 22.56) aufweisen, von der Zulauföffnung oder von der Ablauföffnung des ersten Anschlussteils (12) bzw. des zweiten Anschlussteils trennt oder von einem mit Durchgangsöffnungen von umlaufenden Mediumkanalwandungen anderer Mediumkanäle in Verbindung stehendem Innenraum des Verbindungsteils (13), sodass kein Kühlmedium zwischen den Durchgangsöffnungen (22; 22.1 bis 22.56) in den umlaufenden Mediumkanalwandungen der vorzugsweise benachbarten Mediumkanäle einerseits und der Zulaufkammer (18; 18.1, 18.2) bzw. der Ablaufkammer (20; 20.1, 20.2) bzw. diesem Innenraum andererseits strömen kann.

19. Verfahren zur Herstellung eines Kühlbauteils, insbesondere eines Kühlbauteils gemäß einem oder mehreren der vorhergehenden Ansprüche, das mindestens ein einen Kühlkörper bildendendes, metallisches Profil (11) aufweist, das über mehrere parallele, längliche Mediumkanäle (14) zum Durchfluss von Kühlmedium verfügt, von denen jeder jeweils seitlich von einer umlaufenden, durch das Profil (11) gebildeten Mediumkanalwandung (16) begrenzt wird, und mit einem mit dem Profil (11) fluiddicht verbundenen ersten Anschlussteil (12) aus Kunststoff mit Zulauf- und/oder Ablauföffnung, über die dem Kühlbauteil Kühlmedium zuführbar ist bzw. über die Kühlmedium aus dem Kühlbauteil abführbar ist, wobei die umlaufende Mediumkanalwandung (16) mindestens eines der parallelen Mediumkanäle (14), im Bereich des ersten Anschlussteils (12) eine Durchgangsöffnung (22; 22.1 bis 22.56) aufweist, über die der Mediumkanal (14) fluidleitend mit der Zulauf- bzw. mit der Ablauföffnung des ersten Anschlussteils (12) verbunden ist, wobei das Profil (11) ausgebildet ist mit einer ersten großflächigen Außenseite und mit einer von dieser beabstandeten zweiten großflächigen Außenseite, wobei die oder jede im Bereich des ersten Anschlussteils (12) angeordnete Durchgangsöffnung (22; 22.1 bis 22.56) an der ersten oder der zweiten großflächigen Außenseite des Profils (11) angeordnet ist, mit folgenden Maßnahmen:
a) Einbringen der Durchgangsöffnung (22; 22.1 bis 22.56) in ein vorgefertigtes, metallisches, die Mediumkanäle (14) und die Mediumkanalwandungen (16) aufweisendes Profil (11) in Form einer in die umlaufende Mediumkanalwandung (16) eingebrachten Freimachung, insbesondere mittels Trennen und/oder Umformen, wie etwa Bohren, Stanzen, Pressen und/oder Biegen, vorzugsweise mittels Laser, Bohreinrichtung, Stanzeinrichtung, Presseinrichtung und/oder Biegeeinrichtung,
b) Fluiddichtes Verbinden eines vorgefertigten, insbesondere spritzgegossenen Anschlussteils (12) aus Kunststoff mit Zulauf- und/oder Ablauföffnung im Bereich der Durchgangsöffnung (22; 22.1 bis 22.56), insbesondere durch Verpressen von Verbindungsflächen des Anschlussteils (12) mit Verbindungsflächen des Profils (11), vorzugsweise unter Verwendung von Wärme zum Aufschmelzen der Verbindungsflächen des Anschlussteils (12).

20. Verfahren gemäß Anspruch 19, **dadurch gekennzeichnet, dass** in die Verbindungsflächen des Profils (11) vor dem Verpressen jeweils insbesondere mittels physikalischer und/oder chemischer Nano- oder Mikrostrukturierungsverfahren dreidimensionale Nano- und/oder Mikrostrukturen eingebracht werden.

21. Verfahren gemäß Anspruch 19 oder 20, **dadurch gekennzeichnet, dass** die Verbindungsflächen des Profils (11), insbesondere mittels Induktion, vor dem Verpressen durch Zuführen oder Erzeugen von Wärme auf eine Temperatur gebracht werden, die mindestens der Erweichungstemperatur des Kunststoffs des Anschlussteils (12) entspricht.

22. Verfahren gemäß einem oder mehreren der vorhergehenden Ansprüche 19-21, **dadurch gekennzeichnet, dass** die Mediumkanäle (14) des Profils (11) an ihren gegenüberliegenden Enden stirnseitig verschlossen werden durch Verpressen jedes der beiden, die jeweiligen Enden der Mediumkanäle (14) aufweisenden Profilenden, sodass jeweils eine Bindenaht entsteht.

23. Verfahren gemäß Anspruch 22, **dadurch gekennzeichnet, dass** jede der beiden Bindenähte fluiddicht verschlossen wird, insbesondere durch Verschweißen oder Verlöten.

## Claims

1. A cooling component for cooling objects, with at least one metal profile (11), which forms a heat sink, wherein the profile (11) has several parallel, elongated medium channels (14) for the flow of cooling medium therethrough, each of which is in each case delimited by a circumferential medium channel wall (16), which is formed by the profile (11), and with a first connection part (12) made of plastic, which is connected to the profile (11) in a fluid-tight manner, with inlet and/or outlet opening, via which cooling medium can be fed to the cooling component or via which cooling medium can be discharged from the cooling component, **characterized in that**, in the region of the first connection part (12), the circumferential medium channel wall (16) of at least one of the parallel medium channels (14) has a through opening (22; 22.1 to 22.56) in the form of a clearance introduced into the circumferential medium channel wall (16), via which the medium channel (14) is fluidically connected to the inlet or to the outlet opening, respectively, of the first connection part (12), wherein the profile (11) is formed with a first large-surface outer side and with a second large-surface outer side spaced apart therefrom, wherein the or each through opening (22; 22.1 to 22.56) arranged in the region of the first connection part (12) is arranged on the first or the second large-surface outer side of the profile (11).

2. The cooling component according to claim 1, **characterized in that** the parallel medium channels (14) are closed on the front side on their opposite ends, **in that** opposite sections of the respective circumferential medium channel wall (16) of the respective medium channel (14) are connected to one another in a fluid-tight manner, preferably in a non-positive manner and/or by means of a substance-to-substance bond, particularly preferably by compression and/or welding of the opposite sections.

3. The cooling component according to claim 1 or 2, **characterized in that** the through openings (22; 22.1 bis 22.56) of the circumferential medium channel walls (16) of a group of medium channels (14) arranged next to one another form a common, cohesive profile opening (23), which in particular extends transversely to the medium channels (14).

4. The cooling component according to claim 1 or 2, **characterized in that** the through openings (22; 22.1 bis 22.56) of the circumferential medium channel walls (16) of a group of medium channels (14), which are in each case arranged next to one another, of the profile (11) are in each case separated from one another by preferably parallel material webs (14) formed by the profile (11), in particular the circumferential medium channel walls (16).

5. The cooling component according to one or several of the preceding claims, **characterized in that** the through openings (22; 22.1 to 22.56) of the circumferential medium channel walls (16) of a group of medium channels (14), which are in each case arranged next to one another, of the profile (11) are arranged in a common (unbent) plane.

6. The cooling component according to one or several of the preceding claims, **characterized in that** the circumferential medium channel walls (16) of two adjacent medium channels (14) have a common wall section, which is arranged between the medium channels (14) and which in particular extends from one end of the profile to the other end of the profile, and which the two adjacent medium channels (14) adjoin in each case.

7. The cooling component according to one or several of the preceding claims, **characterized in that** the circumferential medium channel walls of a first subgroup of the medium channels (14) running in parallel in each case have a through opening (22; 22.1 to 22.56), via which the respective medium channel (14) is fluidically connected to the inlet or the outlet opening, respectively, of the first connection part (12), and that the circumferential medium channel walls of a second subgroup of medium channels in each case have a through opening (22; 22.1 to 22.56), via which the respective medium channel (14) is non-fluidically connected to the inlet or the outlet opening, respectively, of the first connection part (12), but which is closed to the outside in a fluid-tight manner, in particular by means of the first connection part (12).

8. The cooling component according to one or several of the preceding claims, **characterized in that** the profile (11) is formed in one piece.

9. The cooling component according to one or several of the preceding claims, **characterized in that** the profile (11) is formed with the first large-surface, in particular flat, bent or corrugated outer side, with the second large-surface, in particular flat, bent or corrugated outer side spaced apart therefrom and in particular running parallel thereto, as and with two in particular flat, bent or corrugated narrow outer sides, which are spaced apart from one another and which in each case connect the first and the second large-surface outer side to one another.

10. The cooling component according to one or several of the preceding claims, **characterized in that** the first connection part (12) and the or each through opening (22; 22.1 to 22.56) arranged in the region of the first connection part (12) is arranged in the region of a first end of the profile (11), in particular at a distance therefrom or in a central region of the profile (11).

11. The cooling component according to one or several of the preceding claims, **characterized in that** the first connection part (12) has an inlet chamber (18; 18.1, 18.2) comprising the inlet opening (19), into which the through opening (22; 22.1 to 22.56) of the circumferential medium channel wall (16) of the (optionally respective) medium channel (14) leads, and via which the medium channel (14) is fluidically connected to the inlet opening, and/or that the first connection part (12) has an outlet chamber (20; 20.1, 202), which is in particular separated from the inlet chamber (18; 18.1, 18.2) and which comprises the outlet opening (21) and into which the through opening (22; 22.1 to 22.56) of the circumferential medium channel wall (16) of the (optionally respective) medium channel (14) leads, via which the medium channel (14) is fluidically connected to the outlet opening.

12. The cooling component according to one or several of the preceding claims, **characterized in that** the circumferential medium channel wall (16) of the (optionally respective) medium channel (14), preferably the respective circumferential medium channel wall (16) of the several or all medium channels (14), has a further through opening (22; 22.1 to 22.56) in the region of a second connection part made of plastic, which is fluidically connected to the profile (11), in particular a clearance introduced into the circumferential medium channel wall (16), via which the medium channel (14) is fluidically connected to an inlet or outlet opening of the further connection part (12).

13. The cooling component according to one or several of the preceding claims, **characterized in that** the circumferential medium channel wall (16) of the (optionally respective) medium channel (14), preferably the respective circumferential medium channel wall (16) of the several of or all medium channels (14), has a further through opening (22; 22.1 to 22.56) in the region of a connector made of plastic, which is connected to the profile (11) in a fluid-tight manner and via which said medium channel (14) is fluidically connected to an interior space of the connector, wherein said interior space, in turn, is fluidically connected to at least one further one of the parallel medium channels (14) via a through opening (22; 22.1 to 22.56), which is arranged in the region of the connector, in the circumferential medium channel wall (16) of the further medium channel (14).

14. The cooling component according to one or several of the preceding claims 12 or 13, **characterized in that** the second connection part or the connector (13) as well as the or each through opening (22; 22.1 to 22.56) arranged in the region of the second connection part or of the connector, respectively, is arranged at a distance in the region of a second end of the profile (11) lying opposite the first end, namely at a distance from the second end, or that the second connection part is arranged in a central region of the profile (11) together with the first connection part (12).

15. The cooling component according to one or several of the preceding claims, at least according to claim 6, **characterized in that** the common wall section of the circumferential medium channel wall (16) of the two adjacent medium channels (14) is interrupted in at least one region, in particular in at least one end region of the adjacent medium channels (14), or has a connection opening, so that cooling medium can flow from the one to the other medium channel (14) there.

16. The cooling component according to claim 15, **characterized in that** the common wall section separates the two medium channels (14) from one another in a fluid-tight manner outside the or each region, in which the wall section is interrupted or outside the or each connection opening.

17. The cooling component according to one or several of the preceding claims, **characterized in that** the first connection part (12) and/or the second connection part and/or the connector (13), in particular one or several walls thereof, is formed in such a way that it separates at least one medium channel (14), in particular a medium channel (14), which has a through opening (22; 22.1 to 22.56), which is preferably introduced by means of separating and/or shaping, in its circumferential medium channel wall (16) in the region of the first connection part (12) or of the second connection part or of the connector (13), from the inlet chamber (18; 18.1, 18.2) or the outlet chamber (20; 20.1, 20.2) of the first connection part (12) or of the second connection part, respectively, or from the interior space of the connector (13), so that no cooling medium can flow between said through opening (22; 22.1 to 22.56) on the one hand and the inlet chamber (18; 18.1, 18.2) or the outlet chamber (20; 20.1, 20.2), respectively, or the interior space, respectively, on the other hand.

18. The cooling component according to one or several of the preceding claims, **characterized in that** the first connection part (12) and/or the second connection part and/or the connector (13), in particular one or several walls thereof, is formed in such a way that - by forming a connection channel between them - it separates at least two preferably adjacent medium channels (14), which each have a through opening (22; 22.1 to 22.56) - which is preferably introduced by separating and/or shaping - in the circumferential medium channel wall (16) thereof in the region of the first connection part (12) or of the second connection part or of the connector (13), from the inlet opening or from the outlet opening of the first connection part (12) or of the second connection part, respectively, or from an interior space of the connector (13), which is in contact with through openings of circumferential medium channel walls of other medium channels, so that no cooling medium can flow between the through openings (22; 22.1 to 22.56) in the circumferential medium channel walls of the preferably adjacent medium channels on the one hand and the inlet chamber (18; 18.1, 18.2) or the outlet chamber (20; 20.1, 20.2), respectively, or said interior space, respectively, on the other hand

19. A method for producing a cooling component, in particular a cooling component according to one or several of the preceding claims, which has at least one metal profile (11) forming a heat sink and which has several parallel, elongated medium channels (14) for the flow of cooling medium therethrough, each of which is in each case laterally delimited by a circumferential medium channel wall (16), which is formed by the profile (11), and with a first connection part (12) made of plastic, which is connected to the profile (11) in a fluid-tight manner with inlet and/or outlet opening, via which cooling medium can be fed to the cooling component, or via which cooling medium can be discharged from the cooling component, respectively, wherein the circumferential medium channel wall (16) of at least one of the parallel medium channels (14) has, in the region of the first connection part (12), a through opening (22; 22.1 to 22.56), via which the medium channel (14) is fluidically connected to the inlet and/or to the outlet opening, respectively, of the first connection part (12), wherein the profile (11) is formed with a first large-surface outer side and with a second large-surface outer side spaced apart therefrom, wherein the or each through opening (22; 22.1 to 22.56) arranged in the region of the first connection part (12) is arranged on the first or the second large-surface outer side of the profile (11) with the following measures:
a) introducing the through opening (22; 22.1 to 22.56) into a prefabricated, metal profile (11) in the form of a clearance introduced into the circumferential medium channel wall (16) having the medium channels (14) and the medium channel walls (16), in particular by means of separating and/or shaping, such as, for example, drilling, punching, pressing and/or bending, preferably by means of laser, drilling device, punching device, pressing device and/or bending device,
b) fluid-tight connecting of a prefabricated, in particular injection molded connection part (12) made of plastic with inlet and/or outlet opening in the region of the through opening (22; 22.1 to 22.56), in particular by compressing connection surfaces of the connection part (12) with connection surfaces of the profile (11), preferably with the use of heat for melting the connection surfaces of the connection part (12).

20. The method according to claim 19, **characterized in that** three-dimensional nanostructures and/or microstructures are in each case introduced into the connection surfaces of the profile (11) prior to the compressing in particular by means of physical and/or chemical nano-structuring or micro-structuring methods.

21. The method according to claim 19 or 20, **characterized in that** the connection surfaces of the profile (11) are brought to a temperature, which corresponds at least to the softening temperature of the plastic of the connection part (12), in particular by means of induction prior to the compressing by feeding or generating heat.

22. The method according to one or several of the preceding claims 19-21, **characterized in that** the medium channels (14) of the profile (11) are closed on the front side on their opposite ends by compressing each of the two profile ends having the respective ends of the medium channels (14), so that a weld line is created in each case.

23. The method according to claim 22, **characterized in that** each of the two weld seams is closed in a fluid-tight manner, in particular by means of welding or soldering.

## Revendications

1. Composant de refroidissement pour refroidir des objets, comprenant au moins un profilé métallique (11) formant un dissipateur thermique, le profilé (11) présentant plusieurs canaux de fluide parallèles et allongés (14) pour le passage d'un fluide de refroidissement, chacun d'entre eux étant délimité par une paroi périphérique de canal de fluide (16) formée par le profilé (11), et avec une première pièce de raccordement (12) en matière plastique reliée au profilé (11) de manière étanche aux fluides et comportant une ouverture d'arrivée et/ou de sortie par laquelle le fluide de refroidissement peut être amené au composant de refroidissement ou évacué du composant de refroidissement, **caractérisé en ce que** la paroi périphérique de canal de fluide (16) d'au moins l'un des canaux parallèles de fluide (14) présente, dans la zone de la première pièce de raccordement (12), une ouverture de passage (22 ; 22.1 à 22.56) sous la forme d'un dégagement pratiqué dans la paroi périphérique (16) du canal de fluide, par l'intermédiaire duquel le canal de fluide (14) est relié de manière fluidique à l'ouverture d'arrivée ou à l'ouverture de sortie de la première pièce de raccordement (12), le profilé (11) est formé avec une première face extérieure de grande surface et une deuxième face extérieure de grande surface espacée de celle-ci, l'ouverture de passage (22 ; 22.1 à 22.56) ou chaque ouverture de passage disposée dans la zone de la première pièce de raccordement (12) étant disposée sur la première ou la deuxième face extérieure de grande surface du profilé (11).

2. Composant de refroidissement selon la revendication 1, **caractérisé en ce que** les canaux de fluide parallèles (14) sont fermés à leurs extrémités opposées par des parois frontales, des sections opposées de la paroi périphérique respective de canal de fluide (16) du canal de fluide respectif (14) étant reliées entre elles de manière étanche aux fluides, de préférence par liaison matière et/ou par liaison mécanique, de préférence par compression et/ou soudage des sections opposées.

3. Composant de refroidissement selon la revendication 1 ou 2, **caractérisé en ce que** les ouvertures de passage (22; 22.1 à 22.56) des parois périphériques de canaux de fluide (16) d'un groupe de canaux de fluide (14) disposés les uns à côté des autres forment une ouverture profilée commune, continue, s'étendant en particulier transversalement aux canaux de fluide (14).

4. Composant de refroidissement selon la revendication 1 ou 2, **caractérisé en ce que** les ouvertures de passage (22; 22.1 à 22.56) des parois périphériques de canaux de fluide (16) d'un groupe de canaux de fluide (14) du profilé (11) disposés les uns à côté des autres sont séparées les unes des autres par des nervures de matière de préférence parallèles formées à partir du profilé (11), en particulier des parois périphériques des canaux de fluide (16).

5. Composant de refroidissement selon une ou plusieurs des revendications précédentes, **caractérisé en ce que** les ouvertures de passage (22; 22.1 à 22.56) des parois périphériques de canaux de fluide (16) d'un groupe de canaux de fluide (14) du profilé (11) disposés les uns à côté des autres sont disposées dans un plan commun (non courbé).

6. Composant de refroidissement selon une ou plusieurs des revendications précédentes, **caractérisé en ce que** les parois périphériques (16) de canal de fluide de deux canaux de fluide (14) adjacents présentent une section de paroi commune, disposée entre les canaux de fluide (14), s'étendant en particulier d'une extrémité du profilé à l'autre extrémité du profilé, à laquelle les deux canaux de fluide (14) adjacents sont respectivement adjacents.

7. Composant de refroidissement selon une ou plusieurs des revendications précédentes, **caractérisé en ce que** les parois périphériques des canaux de fluide d'un premier sous-groupe de canaux de fluide (14) parallèles présentent chacune une ouverture de passage (22 ; 22.1 à 22.56) par laquelle le canal de fluide respectif (14) est relié de manière fluidique à l'ouverture d'entrée ou de sortie de la première pièce de raccordement (12), et **en ce que** les parois périphériques des canaux de fluide d'un deuxième sous-groupe de canaux de fluide présentent chacune une ouverture de passage (22 ; 22.1 à 22.56) par laquelle le canal de fluide respectif (14) n'est pas relié de manière fluidique à l'ouverture d'entrée ou de sortie de la première pièce de raccordement (12), mais qui est fermée de manière étanche aux fluides vers l'extérieur, en particulier par la première pièce de raccordement (12).

8. Composant de refroidissement selon une ou plusieurs des revendications précédentes, **caractérisé en ce que** le profilé (11) est réalisé d'un seul tenant.

9. Composant de refroidissement selon une ou plusieurs des revendications précédentes, **caractérisé en ce que** le profilé (11) est formé avec la première face extérieure de grande surface, en particulier plane, courbée ou ondulée, avec la deuxième face extérieure de grande surface, en particulier plane, courbée ou ondulée, espacée de celle-là et s'étendant en particulier parallèlement à celle-là, et avec deux faces extérieures étroites espacées l'une de l'autre, la première et la deuxième faces extérieures de grande surface en particulier plane, courbée ou ondulée, reliées respectivement entre elles.

10. Composant de refroidissement selon une ou plusieurs des revendications précédentes, **caractérisé en ce que** la première pièce de raccordement (12) et la ou chaque ouverture de passage (22; 22.1 à 22.56) disposée dans la zone de la première pièce de raccordement (12) sont disposées dans la zone d'une première extrémité du profilé (11), en particulier à distance de celle-ci, ou dans une zone centrale du profilé (11).

11. Composant de refroidissement selon une ou plusieurs des revendications précédentes, **caractérisé en ce que** la première pièce de raccordement (12) présente une chambre d'alimentation (18 ; 18.1, 18.2) comprenant l'ouverture d'alimentation (19), dans laquelle débouche l'ouverture de passage (22 ; 22.1 à 22.56) de la paroi périphérique (16) du canal de fluide (14) (éventuellement respectif) débouche, par l'intermédiaire de laquelle le canal de fluide (14) est relié de manière fluidique à l'ouverture d'alimentation, et/ou **en ce que** la première pièce de raccordement (12) présente une chambre de sortie (20 ; 20.1, 20.2) qui comprend l'ouverture d'écoulement (21), séparée notamment de la chambre d'alimentation (18 ; 18.1, 18.2), dans laquelle débouche l'ouverture de passage (22 ; 22.1 à 22.56) de la paroi périphérique (16) du canal de fluide (14) (éventuellement respectif), par l'intermédiaire de laquelle le canal de fluide (14) est relié de manière fluidique à l'ouverture d'écoulement.

12. Composant de refroidissement selon une ou plusieurs des revendications précédentes, **caractérisé en ce que** la paroi périphérique (16) du canal de fluide (14) (éventuellement respectif), de préférence la paroi périphérique respective (16) de plusieurs ou de tous les canaux de fluide (14), présente, dans la zone d'une deuxième pièce de raccordement en plastique reliée de manière étanche aux fluides au profilé (11), une autre ouverture de passage (22 ; 22.1 à 22.56), en particulier une ouverture pratiquée dans la paroi périphérique (16) du canal de fluide, par laquelle le canal de fluide (14) est relié de manière fluidique à une ouverture d'entrée ou de sortie de l'autre pièce de raccordement (12).

13. Composant de refroidissement selon une ou plusieurs des revendications précédentes, **caractérisé en ce que** la paroi périphérique (16) du canal de fluide (14) (éventuellement respectif), de préférence la paroi périphérique respective (16) des plusieurs ou de tous les canaux de fluide (14), présente une autre ouverture de passage (22 ; 22.1 à 22.56), dans la zone d'une pièce de liaison en matière plastique reliée de manière étanche aux fluides au profilé (11), par l'intermédiaire de laquelle ce canal de fluide (14) est relié de manière fluidique à un espace intérieur de la pièce de liaison, cet espace intérieur étant à son tour relié de manière fluidique à au moins un autre des canaux de fluide parallèles (14) par l'intermédiaire d'une ouverture de passage (22 ; 22.1 à 22.56) ménagée dans la zone de la pièce de liaison disposée dans la paroi périphérique (16) de canal de fluide de l'autre canal de fluide (14).

14. Composant de refroidissement selon une ou plusieurs des revendications 12 ou 13 précédentes, **caractérisé en ce que** la deuxième pièce de raccordement ou la pièce de liaison (13) ainsi que la ou chaque ouverture de passage (22 ; 22.1 à 22.56) disposée dans la zone de la deuxième pièce de raccordement ou de la pièce de liaison est disposée à distance dans la zone d'une deuxième extrémité du profilé (11) opposée à la première extrémité, et ce à distance de la deuxième extrémité, ou **en ce que** la deuxième pièce de raccordement est disposée avec la première pièce de raccordement (12) dans une zone centrale du profilé (11).

15. Composant de refroidissement selon une ou plusieurs des revendications précédentes, au moins selon la revendication 6, **caractérisé en ce que** la section de paroi commune de la paroi périphérique (16) de canal de fluide des deux canaux de fluide adjacents (14) est interrompue ou présente une ouverture de liaison dans au moins une zone, en particulier dans au moins une zone d'extrémité des canaux de fluide adjacents (14), de sorte que le fluide de refroidissement peut s'écouler d'un canal de fluide (14) à l'autre.

16. Composant de refroidissement selon la revendication 15, **caractérisé en ce que** la section de paroi commune sépare les deux canaux de fluide (14) de manière étanche aux fluides à l'extérieur de la ou de chaque zone dans laquelle la section de paroi est interrompue ou à l'extérieur de la ou de chaque ouverture de liaison.

17. Composant de refroidissement selon une ou plusieurs des revendications précédentes, **caractérisé en ce que** la première pièce de raccordement (12) et/ou la deuxième pièce de raccordement et/ou la pièce de liaison (13), en particulier une ou plusieurs parois de celle-ci, est conçue de telle sorte qu'elle sépare au moins un canal de fluide (14), en particulier un canal de fluide (14) qui présente, dans sa paroi périphérique (16) de canal de fluide dans la zone de la première pièce de raccordement (12) ou de la deuxième pièce de raccordement ou de la pièce de liaison (13) une ouverture de passage (22 ; 22.1 à 22.56), de préférence par séparation et/ou déformation, de la chambre d'alimentation (18 ; 18.1, 18.2) ou de la chambre d'évacuation (20 ; 20.1, 20.2) de la première pièce de raccordement (12) ou de la deuxième pièce de raccordement, ou de l'espace intérieur de la partie de liaison (13), de sorte qu'aucun fluide de refroidissement ne puisse circuler entre cette ouverture de passage (22. 22.1 à 22.56) d'une part et la chambre d'alimentation (18 ; 18.1, 18.2) ou la chambre d'évacuation (20 ; 20.1, 20.2) ou l'espace intérieur d'autre part.

18. Composant de refroidissement selon une ou plusieurs des revendications précédentes, **caractérisé en ce que** la première pièce de raccordement (12) et/ou la deuxième pièce de raccordement et/ou la pièce de liaison (13), en particulier une ou plusieurs parois de celle-ci, est conçue de telle sorte qu'elle sépare, en créant un canal de liaison entre elles, au moins deux canaux de fluide de préférence adjacents (14), qui présentent chacun dans leur paroi périphérique (16) de canal de fluide dans la zone de la première pièce de raccordement (12) ou de la deuxième pièce de raccordement ou de la pièce de liaison (13) une ouverture de passage (22 ; 22.1 à 22.56), de préférence par séparation et/ou déformation, de la chambre d'alimentation ou de la chambre d'évacuation de la première pièce de raccordement (12) ou de la deuxième pièce de raccordement, ou d'un espace intérieur de la pièce de liaison (13) relié à des ouvertures de passage des parois périphériques des canaux de fluide d'autres canaux de fluide, de sorte qu'aucun fluide de refroidissement ne s'écoule entre les ouvertures de passage (22; 22.1 à 22.56) dans les parois périphériques des canaux de fluide des canaux de fluide de préférence adjacents d'une part et la chambre d'alimentation (18 ; 18.1, 18.2) ou la chambre d'évacuation (20 ; 20.1, 20.2) ou cet espace intérieur d'autre part.

19. Procédé de fabrication d'un composant de refroidissement, en particulier d'un composant de refroidissement selon une ou plusieurs des revendications précédentes, qui présente au moins un profilé métallique (11) formant un dissipateur thermique, qui comporte plusieurs canaux de fluide parallèles et allongés (14) pour le passage d'un fluide de refroidissement, dont chacun est délimité latéralement par une paroi de canal de fluide (16) périphérique formée par le profilé (11), et avec une première pièce de raccordement (12) en matière plastique reliée de manière étanche aux fluides au profilé (11) avec une ouverture d'alimentation et/ou de sortie, par laquelle le fluide de refroidissement peut être amené au composant de refroidissement ou par laquelle le fluide de refroidissement peut être évacué du composant de refroidissement, la paroi périphérique (16) du canal de fluide d'au moins l'un des canaux de fluide parallèles (14) présentant, dans la zone de la première pièce de raccordement (12), une ouverture de passage (22 ; 22.1 à 22.56) par l'intermédiaire de laquelle le canal de fluide (14) est relié de manière fluidique à l'ouverture d'arrivée ou à l'ouverture de sortie de la première pièce de raccordement (12), le profilé (11) étant réalisé avec une première face extérieure de grande surface et une deuxième face extérieure de grande surface espacée de celle-ci, l'ouverture de passage (22 ; 22.1 à 22.56) ou chacune des ouvertures de passage disposées dans la zone de la première pièce de raccordement (12) étant disposée sur la première ou la deuxième surface extérieure de grande taille du profilé (11), avec les mesures suivantes :
a) insertion de l'ouverture de passage (22 ; 22.1 à 22.56) dans un profilé métallique préfabriqué (11) comportant les canaux de fluide (14) et les parois périphériques de canal de fluide (16), sous la forme d'un dégagement réalisé dans la paroi périphérique (16) de canal de fluide, en particulier par séparation et/ou déformation, telle que perçage, poinçonnage, pressage et/ou pliage, de préférence au moyen d'un laser, d'un dispositif de perçage, d'un dispositif de poinçonnage, d'un dispositif de pressage et/ou d'un dispositif de pliage,
b) raccordement étanche aux fluides d'une pièce de raccordement préfabriquée (12), en particulier moulée par injection, en matière plastique, avec une ouverture d'arrivée et/ou de sortie dans la zone de l'ouverture de passage (22 ; 22.1 à 22.56), en particulier par compression des surfaces de raccordement de la pièce de raccordement (12) avec les surfaces de raccordement du profilé (11), de préférence en utilisant de la chaleur pour faire fondre les surfaces de raccordement de la pièce de raccordement (12).

20. Procédé selon la revendication 19, **caractérisé en ce que** des nanostructures et/ou microstructures tridimensionnelles sont introduites dans les surfaces de liaison du profilé (11) avant le pressage, en particulier au moyen de procédés de nanostructuration ou de micro- structuration physiques et/ou chimiques.

21. Procédé selon la revendication 19 ou 20, **caractérisé en ce que** les surfaces de liaison du profilé (11) sont amenées, en particulier par induction, avant le pressage, par apport ou production de chaleur, à une température qui correspond au moins à la température de ramollissement de la matière plastique de la pièce de raccordement (12).

22. Procédé selon une ou plusieurs des revendications précédentes 19 à 21, **caractérisé en ce que** les canaux de fluide (14) du profilé (11) sont fermés à leurs extrémités opposées par compression de chacune des deux extrémités du profilé présentant les extrémités respectives des canaux de fluide (14), de manière à former respectivement un cordon de soudure.

23. Procédé selon la revendication 22, **caractérisé en ce que** chacune des deux soudures est fermée de manière étanche aux fluides, en particulier par soudage ou brasage.
